# EUROPEAN PATENT APPLICATION

(11) **EP 0 800 090 A1**
(43) Date of publication of application: **08.10.1997**
(21) Application number: 96935373.9
(22) Date of filing: 18.10.1996
(51) Int. Cl.: G01R 31/02

(54) **CONNECTING CONDITION EXAMINATION APPARATUS, PORTABLE ELECTRONIC EQUIPMENT AND CONNECTING CONDITION EXAMINATION METHOD**

(30) Priority: 20.10.1995 JP 273239/95
(71) Applicant: SEIKO EPSON CORPORATION, Shinjuku-ku Tokyo 163-08 (JP); SEIKO INSTRUMENTS INC., Chiba-shi, Chiba-ken 261 (JP)
(72) Inventor: HAYAKAWA, Motomu Seiko Epson Corporation, Nagano-ken 392 (JP); SAKUMOTO, Kazumi Seiko Instruments Inc., Chiba-ken 261 (JP)
(74) Representative: Sturt, Clifford Mark
(86) International application number: JP9603034
(87) International publication number: WO9714972

(57) **Abstract**

A diagnostic device and a diagnostic method that can diagnose problems such as opens and shorts by diagnosing the connection states of connector areas and wiring areas of circuit configuration areas equipped with circuit elements such as an LED, that enables relative value determination in which the obtained diagnostic value is stored as a normal value if that diagnostic value is judged to be normal, and in which problems are diagnosed by comparing the change in the diagnostic value relative to the normal value with a judgement value. Because the diagnostic method according to the invention can accurately diagnose problems even when the power supply voltage fluctuates or large individual differences exist among circuit elements, processes such as measurement can be reliably performed.

## Description

### Industrial Field of Application

The invention relates to a diagnostic device and a diagnostic method that can detect problems such as opens and shorts in the connection state of circuit configuration areas (circuit configuration elements and circuit configuration regions), such as circuit elements, wires, connectors, and cables, that comprise an electrical circuit, and more particularly to a diagnostic method suitable for testing portable electronic instruments that run on batteries, etc.

### Background Technology

There are many electronic instruments that are used for operations such as measurement and monitoring by connecting an external unit such as a sensor to the main body via a cable, etc. For example, a wrist-mountable pulse wave measurement instrument has been suggested that can calculate pulse count by measuring a pulse wave, and a type of instrument is being evaluated that optically detects the change in blood volume and displays pulse wave information such as pulse count based on the detection result. In this optical pulse wave measurement instrument, a sensor unit (external device) equipped with a light-emitting element such as an LED (light-emitting diode) and a light-receiving element such as a photodiode and phototransistor is mounted on a finger, etc., and part of the light emitted by the LED that is reflected by the finger (blood vessel), etc. is received by the photodiode. By detecting the blood volume change as a change in the amount of received light as explained above, pulse count, etc. can be displayed based on the detection result.

In a wrist-mountable pulse wave measurement instrument, a battery contained inside the device main body is used as the source for driving the sensor unit, and the power is supplied via a cable that connects the main body and the sensor unit. A connector piece is provided on one end of the cable which extends from the sensor unit, and by installing this connector piece in the connector area of the device main body, power is supplied from the device main body to the sensor unit via the cable. At the same time, the signals detected by the sensor unit are input into the device main body via the cable.

In the electronic instrument described above in which an external unit such as a sensor unit is connected using a connector and an extension cable, problems such as opens and shorts tend to occur in the connection areas of the connector and the cable. In particular, in electronic instruments such as a pulse wave measurement instrument that is mounted on an object such as a human body that moves, it is desirable to automatically monitor for problems such as opens and shorts in the connection areas, in order to ensure reliable operations. Let's focus on the connector region, for example. In the connector region which comprises a connector piece which is connected to an external unit and the connector area of the main body, electrical connection must be made between both terminals in multiple locations. However, in portable electronic instruments, the connector piece and the connection area must be connected in a relatively limited space because of a size limitation. Therefore, it is desirable to check for a short or open between the terminals of the connector area formed on the main body side at an appropriate frequency.

In a conventional approach, whether or not a circuit configuration area is shorted is usually checked by measuring the operating voltage of the circuit configuration area, e.g., voltage between terminals, and determining whether or not the value measured exceeds a threshold value (judgement value) that was preset in correspondence to the normal resistance level between the terminals. That is, if the terminal to which the operating voltage is being applied is located near another terminal, in the connector region, and if a short has occurred between these two terminal, the operating voltage will be applied to this other terminal. Therefore, by measuring the voltage of this other terminal and by comparing this voltage value to the specified value, whether or not a short has occurred can be determined.

However, in such a method, it is difficult to set an appropriate judgement value for determining whether or not a short has occurred, and faulty results are often obtained. For example, in electronic instruments that use an electricity-storing device, such as a battery, large-capacity capacitor, and secondary battery, for the power supply area, the output voltage of the electricity-storing device declines as the operation time increases. Consequently, the operating voltage also declines and the operating voltage to be obtained for diagnosing problems also declines. Therefore, the operating voltage (diagnostic value) applied to the other terminal might be below the judgement value even if a short exists. In such a case, an erroneous conclusion that the instrument is normal might be made even though a short has occurred. Furthermore, if the circuit configuration area is provided with circuit elements with relatively large individual differences, the diagnostic values will vary depending on the circuit element. Consequently, it is difficult to pre-set an appropriate judgement value. For example, if variation in electrical characteristics such as resistance exists among the electrical elements to be electrically connected between terminals, that variation will affect the operating voltage level (value). Consequently, the operating voltage between the terminals obtained as the diagnostic value may end up being less than the judgement value even when a short exists, resulting in an erroneous conclusion that the instrument is normal.

It is, therefore, the object of the invention to provide a diagnostic device and a diagnostic method that can accurately detect problems such as opens and shorts even if the diagnostic value obtained for checking for problems in the circuit configuration area varies depending on the power supply voltage and circuit element characteristics. It is another object of the invention to provide a diagnostic device and a diagnostic method in which the process for judging the varying diagnostic value can be performed easily, in which the judgement value, etc. for diagnosis does not require a large memory area, and in which no additional circuit is necessary. It is a further object of the invention to provide a diagnostic device and a diagnostic method that do not require complicated processing or long diagnosis time. It is a still further object of the invention to provide a diagnostic device and a diagnostic method that can provide accurate diagnosis within a short time period, without affecting the measurement process, etc. in instruments such as portable electronic instruments with built-in measurement functions.

### Disclosure of the Invention

The invention is designed to diagnose problems by temporarily storing the diagnostic value that is judged to be normal during the diagnosis as a normal value, comparing this normal value with the next diagnostic value, and comparing the change in the diagnostic value relative to this normal value with the judgement value, so that problems can be determined using a constant judgement value even when the diagnostic value changes. That is, the diagnostic device according to the invention, which can diagnose open or short problems in the circuit configuration area by obtaining diagnostic values based on the operating voltage or operating current that occurs in the circuit configuration area during diagnosis, is provided with an updating means that stores a diagnostic value as a normal value if the diagnostic value is judged to be normal, and with a relative value determination means that diagnoses a problem by comparing the change in the diagnostic value relative to the normal value with the judgement value.

Therefore, at least during the diagnosis, even if the circuit configuration area is driven by the power supplied from an electricity-storing device and the diagnostic value obtained from the circuit configuration area declines due to a drop in the voltage of the electricity-storing device, the diagnostic value obtained at the reduced power supply voltage is stored as a normal value if the diagnostic value is normal. Therefore, even if a problem occurs in the circuit configuration area causing the diagnostic value to change from the normal value to a value exceeding the judgement value, the problem can be accurately diagnosed regardless of how the power supply voltage fluctuates. Furthermore, even if the circuit configuration area is provided with circuit elements with relatively large individual differences, such as an LED, the diagnostic value judged to be normal in the state in which the circuit element is used in the circuit configuration area is stored as a normal value. In this way, a normal value appropriate for that circuit configuration area is set, and thus whether or not a problem has occurred can be determined based on whether or not the diagnostic value has fluctuated from the normal value to a value exceeding the judgement value.

As explained above, by using the diagnostic device according to the invention, problems can be accurately diagnosed by simply providing a judgement value that is appropriate for determining whether or not an open or short has occurred in a particular circuit configuration area, regardless of the change in the power supply voltage or the individual differences in the circuit elements. Therefore, it is not necessary to change the judgement value based on the fluctuations in the power supply voltage or to adjust the judgement value according to the 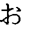 differences in the circuit elements, and the connection state of a circuit configuration area in which the diagnostic value might fluctuate can be determined at a high speed using an extremely simple process. Consequently, the diagnostic device according to the invention can be installed in portable, compact, electronic instruments, and is particularly suitable to such instruments because these instruments operate using an electricity-storing device, such as a battery, as the power supply.

Moreover, because the diagnostic device according to the invention requires a simple diagnostic procedure, it places only a small load on the processing device during diagnosis. Therefore, by adopting a diagnostic area equipped with the function according to the invention for a portable electronic instrument equipped with a main body provided with measurement functions and a sensor area that is connected to said main body via a removable connector and that can detect signals from a measurement target, diagnostic processes can be performed in parallel with the processing by the measurement area which makes measurements, etc., problem occurrence can be monitored on a realtime basis, and more reliable and highly accurate measurements can be made. That is, by providing a measurement area that uses a sensor area to make measurements intermittently and a control area that drives the diagnostic area between these measurements by the measurement area, diagnostic processes can be performed without adversely affecting the speed of the measurement process, enabling highly accurate measurements.

It is also possible to use a fixed value determination means that diagnoses a problem by directly comparing the diagnostic value with the judgement value, in addition to the relative value determination means according to the invention, such that one of these means can be selected using a selection means based on the type of circuit configuration area or problem.

This kind of process which diagnoses the connection state by first temporarily storing a normal value reflecting the state of a circuit configuration area or the power supply voltage can be applied to cases in which measurements are made by connecting an external sensor, etc. to a processing device such as a personal computer (PC). That is, the invention can provide a connection state diagnosis method having the steps described below.
1. An updating process in which a diagnostic value is stored as a normal value if that diagnostic value is judged to be normal.
2. A relative value determination process in which a problem is diagnosed by comparing the change in the diagnostic value relative to the normal value with the judgement value.

Like the aforementioned diagnostic device, the diagnostic method according to the invention is suitable to cases in which, at least during the diagnosis, the circuit configuration area is driven by the power supplied from an electricity-storing device. For example, the method is suitable for diagnosing the connection state of a notebook-type portable personal computer being used for measurements or of a device that is transferring data, in which a battery power supply, etc. is installed in an external unit with an on-board sensor. Furthermore, the diagnostic device and the diagnostic method according to the invention are suitable to devices in which the circuit configuration area is provided with circuit elements with large individual differences, such as an LED. Moreover, by also providing a fixed value determination process that diagnoses a problem by directly comparing the diagnostic value with the judgement value, and by selecting either the relative value determination process or the fixed value determination process beforehand using a selection process and based on the circuit configuration area or the problem type, a determination process suitable to diagnosis can be selected, resulting in an even faster diagnostic process.

Such a connection state diagnostic method according to the invention can be provided as a software program equipped with the aforementioned processes, and can be provided as a program stored in a medium such as a magnetic recording medium or ROM that can be read by a computer or microprocessor.

### Brief Explanation of the Drawings

Fig. 1 is a diagram showing the external appearance of a portable electronic instrument in which a pulse measurement function using the measurement method according to the invention has been installed, and how this instrument is used.

Fig. 2 is a circuit diagram showing a schematic configuration of the portable electronic instrument shown in Fig. 1.

Fig. 3 is a block diagram showing a schematic configuration of the diagnostic area of the portable electronic instrument shown in Fig. 1.

Fig. 4 is a diagram showing an equivalent circuit for detecting a short on the light-emitting side of the electronic instrument shown in Fig. 1.

Fig. 5 is a graph plotting the detection voltage V1 (diagnostic value) obtained when an LED with a large individual difference is used in the equivalent circuit in Fig. 9 against short resistance value RS.

Fig. 6 is a graph plotting the detection voltage V1 (diagnostic value) obtained when an LED with a small individual difference is used in the equivalent circuit in Fig. 9 against short resistance value RS.

Fig. 7 is a graph plotting the detection voltage V1 (diagnostic value) obtained when the operating voltage changes in the equivalent circuit in Fig. 9 against short resistance value RS.

Fig. 8 is a diagram showing an equivalent circuit for detecting an open on the light-emitting side of the electronic instrument shown in Fig. 1.

Fig. 9 is a graph plotting the detection voltage V1 (diagnostic value) obtained in the equivalent circuit in Fig. 8 against open resistance value RO.

Fig. 10 is a diagram showing an equivalent circuit for detecting an open on the light-receiving side of the electronic instrument shown in Fig. 1.

Fig. 11 is a graph plotting the detection voltage V2 (diagnostic value) obtained in the equivalent circuit in Fig. 10 against open resistance value RO.

Fig. 12 is a diagram showing an equivalent circuit for detecting a short on the light-receiving side of the electronic instrument shown in Fig. 1.

Fig. 13 is a graph plotting the detection voltage V2 (diagnostic value) obtained in the equivalent circuit in Fig. 12 against short resistance value RS.

Fig. 14 is a timing diagram for explaining the operation of the diagnostic area shown in Fig. 3.

Fig. 15 is a flow diagram showing the processing in the diagnosis selection area.

Fig. 16 is a flow diagram showing the processing in the fixed value determination area.

Fig. 17 is a flow diagram showing the processing in the relative value comparison area.

Fig. 18 is the top view of the device main body of the portable electronic instrument shown in Fig. 1.

Fig. 19 is a cross-sectional diagram of the pulse wave detection sensor unit used in the portable electronic instrument shown in Fig. 1.

Fig. 20 shows the state in which the sensor unit shown in Fig. 19 is mounted on a finger.

Fig. 21 is a block diagram showing the configuration of the pulse wave processing area.

Fig. 22 is a diagram showing the structure of the connector piece used in the connector region of the electronic instrument shown in Fig. 1.

Fig. 23 is a diagram showing the structure of the connector area used in the connector region of the electronic instrument shown in Fig. 1.

### Ideal Configuration for Implementing the Invention

Next, a configuration example of an embodiment of the invention will be explained with references to the drawings.

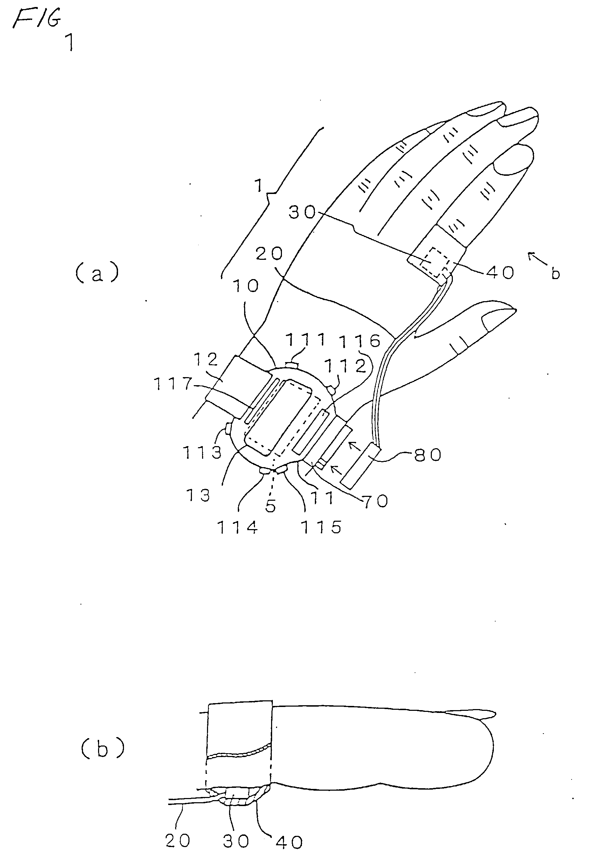

Fig. 1 shows a wrist-mountable portable electronic instrument equipped with the pulse measurement function according to the invention. This portable electronic instrument 1 is provided with a pulse count measurement function that can measure and display a pulse wave, in addition to a clock function that can be used as a wristwatch. As shown in the figure, portable electronic instrument 1 in this embodiment is equipped with device main body 10 possessing a wristwatch structure, and control area 5, etc. for implementing the aforementioned various functions are housed inside this main body 10. Liquid crystal display device 13, which displays various data such as time and pulse count, as well as performing a user-interface function, is installed on the surface of main body 10; and furthermore, multiple operation switches 111, 112, 113, 114, 115, 116, and 117 for controlling the various functions are installed on the top and side surfaces of main body 10. Additionally, pulse wave detection sensor unit 30 is connected to main body 10 via cable 20, so that pulse waves from the finger can be detected. Cable 20 can be connected to or removed from connector area 70 provided in main body 10, using connector piece 80 which is installed at the end of cable 20; whereas sensor unit 30 is mounted on main body 10 when pulse waves are to be measured, and otherwise sensor unit 30 is removed and the instrument can be used as an ordinary wristwatch. Furthermore, wristband 12, which is wrapped around the wrist from the 12 o'clock direction of the wristwatch (hereafter, all directions relative to main body 10 will be indicated in terms of clock directions) and fastened in the 6 o'clock direction, is installed in main body 10, enabling device main body 10 to be detachably mounted on the user's wrist.

Fig. 2 shows a schematic configuration of electronic instrument 1 in this embodiment, with a focus on the mechanisms for pulse wave measurement and diagnosis, using a circuit diagram and a block diagram. Main body 10 of electronic instrument 1 in this embodiment houses control area 5 which comprises several digital-processing devices such as a microprocessor, pulse wave detection circuit 50 equipped with a function for detecting pulse waves using sensor unit 30, diagnostic value detection circuit 60 equipped with a function for obtaining the diagnostic value for diagnosing sensor unit 30, and selection circuit 15 which selects the output signals from said pulse wave detection circuit 50 and from diagnostic value detection circuit 60 and supplies these signals to control area 5. Sensor unit 30 is designed to be installed in connector area 70 provided in main body 10, via connector piece 80 and cable 20, such that the signals from sensor unit 30 are supplied to pulse wave detection circuit 50 and diagnostic value detection circuit 60.

As will be explained in detail below, sensor unit 30 in this embodiment optically detects pulse waves. For this reason, sensor unit 30 has light-emitting area 31 equipped with LED 31a and light-receiving area 32 equipped with photodiode 32a and transistor TR3 for amplification. In correspondence to these components, pulse wave detection circuit 50 provided in main body 10 is equipped with received light signal acquisition circuit 52 and light emission control circuit 51, and these components perform light emission and detection according to signal öa supplied from timing control area 7 of control area 5, described below. Received light signal acquisition circuit 52 is equipped with transistors TR7 and TR6 for controlling photodiode 32a and transistor TR3 for signal amplification, respectively, according to the signal öa timing; and these transistors supply power via terminals 754·834 and terminals 757·837 (only terminal numbers will be used from here on) of connector areas 70 and 80. The received light signal amplified by sensor unit 30 is obtained as a voltage signal via terminals 751·831; and after being amplified by amplification circuit 53 and accumulated, this signal is supplied to control area 5 via selection circuit 15 at the specified timing.

The power supply voltage of voltage Vdd2 is supplied to light-emitting area 31 of sensor unit 30 via terminals 752·832, and the light emission timing and the voltage during light emission are controlled to a certain extent by light emission control circuit 51 which is connected via terminals 753·833. For this reason, light emission control circuit 51 is provided with timing control transistor TR2 which exerts control according to the timing of signal öa and with transistor TR1 for voltage adjustment, so that the voltage can be controlled by comparator 51a and resistors R5 and R6.

Diagnostic value detection circuit 60 in this embodiment is also equipped with light-receiving side detection circuit 62 for acquiring the signal for diagnosing light-receiving area 32 and with light-emitting side detection circuit 61 for diagnosing light-emitting area 31. Light-emitting side detection circuit 61 is controlled by signal öb supplied from timing control area 7; and light-receiving side detection circuit 62 is designed to be able to obtain a diagnostic value in linkage with signal öa which drives received light signal acquisition circuit 52 so that diagnosis can be performed while driving light-receiving area 32.

Light-emitting side detection circuit 61 is equipped with transistor TR5 which is turned on or off by timing signal öb, and with voltage-dividing resistors R1 and R2 for which values close to the resistance component of light-emitting area 31 have been selected to enable easy detection of connection problems such as opens and shorts in light-emitting area 31, and voltage V1 divided by these resistors R1 and R2 is obtained as the diagnostic value. This diagnostic value is supplied to control area 5 via selection circuit 15 at an appropriate timing.

Light-receiving side detection circuit 62 is designed to be able to diagnose opens/shorts based on the state of transistor TR3 of light-receiving area 32; and by applying voltage VRG2 for diagnosis to the wiring supplied to amplification circuit 53 and operating it, this operating voltage can be used for detecting connection problems in light-receiving area 32. Light-receiving side detection circuit 62 is additionally equipped with voltage-dividing resistors R3 and R4 for detecting the operating voltage during diagnosis and with operational amplifier 62a which is configured to hold the voltage value detected by these resistors, so that output voltage V2 of operational amplifier 62a reflecting the operating voltage can be obtained as the diagnostic value. This diagnostic value is supplied to control area 5 via selection circuit 15 at an appropriate timing. In this way, light-emitting side detection circuit 61 and light-receiving side detection circuit 62 in this embodiment can obtain the signal intensities that are based on the operating voltages in the circuit configuration areas, such as light-emitting area 31 and light-receiving area 32 to be diagnosed, as diagnostic values.

Furthermore, connector chip 80 of this embodiment is equipped with terminals 755·835 and terminals 756·836 for connection verification so that whether or not connector chip 80 is installed in connector area 70, i.e., whether or not sensor unit 30 is installed, can be determined. Voltage Vdd from battery 59 is applied to terminals 755·835, and terminals 756·836 go high when connector chip 80 is correctly installed in connector area 70. This signal öc is input into diagnostic processing area 65 of control area 5 described below, and whether or not connector chip 80 is present, i.e., whether or not sensor unit 30 is being used, can be determined.

Selection circuit 15 of this embodiment is equipped with three multiplexers ADI0, ADI1, and ADI2, so that the received light signal amplified and accumulated by amplification circuit 53, voltage signal V2 for diagnosis detected by light-receiving side detection circuit 62, or voltage signal V1 for diagnosis detected by light-emitting side detection circuit 61 can be selected and supplied to the analog-digital conversion area 8 (A/D conversion area) of control area 5. Control area 5 of this embodiment is equipped with pulse wave processing area 55 which calculates pulse count by processing the received light signal that has been converted to digital data, diagnostic processing area 65 which diagnoses the connection state of the circuit configuration area using diagnostic value DV that has been converted to digital data, and with a realtime clock having a clock oscillation function, function for measuring time and date, etc., in addition to the aforementioned A/D conversion area 8 and timing control area 7; and is also equipped with clock processing area 6 which performs clock operations as a watch or stopwatch, and with central control area 9 which manages all these processing areas. Electronic instrument 1 of this embodiment is equipped with ROM3 which stores the programs and data necessary for processing in said control area 5, RAM4 to be used as a temporary storage area for processing and for accumulating measurement data, etc., and operation area 2 for controlling control area 5. Operation area 2 is provided with various switches 111 through 117 installed on the top surface or perimeter of main body 10 as explained above. Additionally, electronic instrument 1 of this embodiment is equipped with liquid crystal panel 13 for user interface, and said liquid crystal display device 13 displays information such as time, measured data, a processing mode, and whether or not a problem is present.

### About the diagnostic processing area

Fig. 3 shows the configuration of diagnostic processing area 65 of this embodiment in further details. Diagnostic processing area 65 of this embodiment is equipped with diagnostic selection area 68 which starts diagnostic processing based on an instruction from central control area 9 and which selects a diagnostic function according to the circuit configuration area to be diagnosed or to the problem to be diagnosed, such as open and short. Diagnostic selection area 68 makes a diagnosis by selecting fixed value determination area 67 or relative value comparison area 66 according to the type of signal obtained as diagnostic value DV or the problem to be diagnosed. Fixed value determination area 67 determines whether or not a problem exists by evaluating diagnostic value DV using the threshold value pre-set in threshold value setting area 671 of ROM3 as the judgement value. Relative value comparison area 66 determines whether or not a problem exists by comparing the value that results when diagnostic value DV changes from normal value Vnor stored in normal value storage area 665 of RAM4 with the judgement value set in change magnitude setting area 663 of ROM3. Relative value comparison area 66 is equipped with updating area 661 which updates normal value Vnor with diagnostic value DV if the obtained diagnostic value DV is determined to be normal, and with relative value determination area 662 which determines whether or not a problem exists by comparing the change (magnitude, value, or rate) in diagnostic value DV from normal value Vnor with the judgement value. The functions and processes of these areas will be described in further details below.

### Connection state diagnostic function

The diagnostic function used in diagnostic processing area 65 of this embodiment will be explained below by following the terminals in the connector area. Fig. 2 shows the electrical connections to be made in connector area 70 and connector piece 80 (connector means). Connector area 70 provided in device main body 10 is equipped with terminals 751 through 757, and connector piece 80 is equipped with terminals 831 through 837 which correspond to terminals 751 through 757. For example, terminals 752·832 are terminals with a positive potential (high potential) and used for supplying drive voltage Vdd2 to LED 31a, and terminals 753·833 are terminals with a negative potential (low potential). Terminals 754·834 are terminals for supplying constant drive voltage VRG1 to the cathode terminal of photodiode (FD1) 32a; terminal 751 is a terminal into which the signal from the collector terminal of transistor TR3 which has the same function as a phototransistor is input via terminal 831; terminal 757 is grounding terminal which pulls the emitter terminal of transistor TR3 to the ground potential via terminal 837. Terminals 755 and 756 are terminals which accept, via terminals 835 and 836, the signals for detecting whether or not connector piece 80 has been installed in connector area 70. Note that the aforementioned power supply voltage Vdd2, VRG1, and VRG2 are voltages obtained by converting power supply voltage Vdd.

### Detecting a short in the light-emitting area

The method in which diagnostic processing area 65 of this embodiment detects a short in light-emitting area 31 is explained below. In this embodiment, whether or not light-emitting area 31 connected to terminal 752 and terminal 753 is shorted is determined using voltage V1 acquired by the aforementioned light-emitting side detection circuit 61 and obtained from terminal 753 as the diagnostic value.

Normally, whether or not a short has occurred is determined by checking whether or not the operating voltage in a circuit configuration area has reached or exceeded the specified value. This method is used for the following reason. When a short occurs in the circuit configuration area, the operating voltage at the specified point rises because the resistance component of the circuit element contained in the circuit configuration area can no longer lower the voltage. However, such a method causes several problems in electronic instrument 1 of this embodiment. First, electronic instrument 1 of this embodiment is a portable type and uses a battery as its power supply, and light-emitting area 31 also uses voltage Vdd2, which is obtained by raising battery voltage Vdd to a level that allows LED to emit light, as its power supply. Consequently, when the battery voltage falls, the voltage supplied to LED 31a, i.e., the raised power supply voltage Vdd2, will be substantially lower than the initial state, and as a result, the operating voltage may not reach the judgement value even if a short occurs. Therefore, when checking for a short between terminal 752 and terminal 753 (i.e., light-emitting area 31), accurate diagnosis cannot be made by simply measuring the voltage at terminal 753 using the fact that the drive voltage is being applied to terminal 753, and by diagnosing a short based on whether or not the measurement value exceeds a pre-set threshold value (judgement value).

LED 31a which is a major circuit element of light-emitting area 31 has a large individual variation, and the tolerance in the forward voltage for products normally supplied is around ±50%. Therefore, the magnitude of voltage drop may differ by as much as ±50% depending on the actual element. Consequently, it is extremely difficult to set a judgement value, and a short may be diagnosed even though no short has occurred, or it may be impossible to diagnose a short. As explained above, the electrical characteristics of LED 31a inserted between terminals 752 and 753 may cause the voltage between terminals to fluctuate even during normal operations, and as a result, the diagnostic values that can be obtained also vary widely. Therefore, accurate diagnosis is extremely difficult to obtain if a constant judgement value is used. Furthermore, since there is also certain variation in the resistances of voltage-dividing resistors R1 and R2 used in light-emitting side detection circuit 61, the individual differences in these circuit elements make it even more difficult to set a judgement value.

A more detailed explanation will be provided using an equivalent circuit. Fig. 4 shows an equivalent circuit in which light-emitting area 31 has been shorted. As shown in this figure, short resistor RS becomes connected in parallel with LED 31a when light-emitting area 31 is shorted. This kind of shorted state may occur on the sensor unit 30 side, in cable 20, or in connector area 70 or 80. For example, moisture or a particle may be present in connector area 70 or 80, directly connecting terminals 752·832 and terminals 753·833.

Fig. 5, Fig. 6, and Fig. 7 show the changes in the diagnostic value (voltage V1 for short detection obtained by light-emitting side detection circuit 61 in this embodiment) obtained when short resistance RS changes in the aforementioned equivalent circuit. Fig. 5 shows a case in which the tolerance of the resistance values of voltage-dividing resistors R1 and R2 used in light-emitting side detection circuit 61 in order to obtain short-detection voltage V1 is ±10%, and the tolerance in the forward voltage of LED 31 is ±50%. As can be seen from this figure, short-detection voltage V1 fluctuates greatly. Moreover, the maximum value in the region indicating a normal state where short resistance RS is large is greater than the minimum value in the region indicating a shorted state where short resistance RS is small. Consequently, it is impossible to set a judgement value for determining whether or not a short has occurred.

In contrast, as shown in Fig. 6, the fluctuation in short-detection voltage V1 improves when the tolerance of the resistance values of voltage-dividing resistors R1 and R2 is ±1%, and the tolerance in the forward voltage of LED 31 is ±30%. In this case, the minimum value in the region where short resistance RS is small is greater than the maximum value in the region where short resistance RS is large, and thus it is possible to set a judgement value for determining whether or not a short has occurred. However, in reality, it is difficult to narrow the tolerance values of circuit elements, such as resistor elements and LED elements, to the aforementioned level, and parts supply and inspection will result in substantial cost increases. Furthermore, even if circuit elements with extremely small individual differences are used, it is not possible to solve the other problem described above, i.e., the fluctuation in the power supply potential.

Fig. 7 shows the relationship between short resistance RS and short-detection voltage V1 when power supply voltage (drive voltage) Vdd2 used for driving light-emitting area 31 is varied from 6 V, to 5.5 V, to 5 V, to 4.5 V, and to 4 V, using the same circuit elements as those used in Fig. 6. As explained above, power supply voltage Vdd2 being supplied to light-emitting area 31 fluctuates more widely than the battery voltage; and as can be seen from the figure, when the power supply voltage fluctuates, the maximum value in the region where short resistance RS is large becomes greater than the minimum value in the region where short resistance RS is small. Consequently, it becomes impossible to set a judgement value in the case shown in Fig. 7 as well. For example, let's consider the circuit state to be normal when the value of short resistance RS is 1 x 10⁷ Ù or greater, and to be shorted when the value of short resistance RS is 1 x 10⁵ Ù or smaller. In this case, if drive voltage Vdd2 remains at 5.5 V, whether or not a short has occurred can be detected by configuring a circuit using only electrical elements with tight tolerance values and by setting the judgement value at 1.5 V, for example. However, if drive voltage Vdd2 falls to 4 V, detection voltage V1 will not reach 1.5 V even if a short has occurred. Consequently, the circuit state will be erroneously judged to be normal even though a short has occurred.

Therefore, electronic instrument 1 of this embodiment makes it possible to diagnose a short in an area such as the aforementioned circuit configuration area, by providing diagnostic processing area 65 with relative value comparison area 66 and by checking the relative value. That is, as can be seen from Fig. 5 or Fig. 7, if a short occurs and changes the resistance value, short-detection voltage V1, i.e., the diagnostic value, rises from the normal value even in cases in which individual differences exist in circuit elements such as LED or in which the power supply voltage fluctuates. Therefore, by storing the diagnostic value before a short occurs as the normal value and by comparing the change from this normal value with the judgement value, whether or not a short has occurred can be determined. This method makes it possible to determine whether or not a short has occurred as long as the change from the normal value is equal to or greater than a certain value, and thus stable and accurate diagnoses can be made without being affected by the individual differences in circuit elements or the fluctuation in the power supply voltage.

In the cases shown in Fig. 5 and Fig. 7, if the short-detection voltage V1 measured becomes higher than the short-detection voltage V1 measured during a normal operation earlier by 0.3 V or more, this difference is set as judgement value V1S (change limit), and it can be concluded that a short has occurred if short-detection voltage V1 measured is equal to or higher than this judgement value V1S. By establishing such a judgement value, a shorted state can be accurately diagnosed in both the case shown in Fig. 5 in which individual differences exist in circuit elements and the case shown in Fig. 7 in which the power supply voltage fluctuates.

For example, if drive voltage Vdd2 is 6 V because a new battery has been installed, the circuit state is normal if the value of short-detection voltage V1 is approximately 1.32 V. Subsequently, whenever short-detection voltage V1 is measured at the specified timing, the short-detection voltage V1 that was measured in the previous round and was judged to be normal is treated as the normal value and the difference between this normal value and the latest short-detection voltage V1 is calculated. Then, it is concluded that a short has occurred if this difference is greater than 0.3 V which is judgement value V1S.

Updating of the normal value using short-detection voltage V1 (diagnostic value) may be performed for each cycle in which pulse wave measurement is started. Alternatively, the normal value can be updated only when the diagnostic value is lower than the normal value, by considering the fact that the power supply voltage continues to drop until a new battery is installed. By updating the normal value using such a method, whether or not a short has occurred can be accurately diagnosed even in cases in which the voltage gradually rises, eventually reaching a shorted state.

### Detecting an open in the light-emitting area

The method in which diagnostic processing area 65 of this embodiment detects an open in light-emitting area 31 is explained below. In this embodiment, whether or not light-emitting area 31 connected to terminal 752 and terminal 753 is in an open state is determined using voltage V1 acquired by the aforementioned light-emitting side detection circuit 61 and obtained from terminal 753 as the diagnostic value.

Normally, whether or not an open has occurred is determined by checking whether or not the operating voltage in a circuit configuration area has fallen to or below the specified value. This method is used for the following reason. When an open occurs in the circuit configuration area, the resistance component contained in the circuit configuration area increases, and thus the operating voltage can be used for checking for an open. Fig. 8 shows an equivalent circuit in which light-emitting area 31 is open. As shown in this figure, open resistor RO becomes connected in series with LED 31a when an open occurs in light-emitting area 31. This kind of open state may occur on the sensor unit 30 side, in cable 20, or in connector area 70 or 80. For example, a particle may be present between connector areas 70 and 80, causing a contact failure in terminals 752·832 or terminals 753·833.

Fig. 9 shows the changes in the diagnostic value (open-detection voltage V1 in this case) obtained in light-emitting side detection circuit 61, when open resistance RO changes. As in Fig. 5, Fig. 9 shows a case in which the tolerance of the resistance values of voltage-dividing resistors R1 and R2 in light-emitting side detection circuit 61 is ±10% and the tolerance in the forward voltage of LED 31a is ±50%. As shown in Fig. 9, the value of open-detection voltage V1 fluctuates greatly in the region indicating a normal state in which open resistance RO is small. However, the values of open-detection voltage V1 in the region indicating an open state in which open resistance RO is large converge to a nearly constant value, and its maximum value is smaller than the minimum value in the region in which open resistance RO is small. Therefore, it is possible to set judgement value V1O for diagnosing an open state.

For example, if the circuit state is considered to be normal when open resistance RO is 1 x 10⁶ Ù or smaller, and to be open when open resistance RO is 1 x 10⁷ Ù or greater, judgement value (threshold value) V1O can be set at around 0.5 V in this embodiment. Then, the circuit state can be determined to be normal if open-detection voltage V1 (diagnostic value) exceeds 0.5 V and to be open if open-detection voltage V1 is equal to or less than 0.5 V.

### Detecting an open in the light-receiving area

The method in which diagnostic processing area 65 of this embodiment detects an open in light-receiving area 32 is explained below. In this embodiment, whether or not transistor TR3 of light-receiving area 32 connected to terminal 751 and terminal 757, from which received light signals are obtained, is in an open state is determined using voltage V2 acquired by the aforementioned light-receiving side detection circuit 62 and obtained from terminal 751 as the diagnostic value. As shown in Fig. 2, light-receiving side detection circuit 62 in this embodiment applies voltage VRG2 to terminal 751 during diagnosis and uses voltage V2 obtained by voltage-dividing resistors R3 and R4 as the diagnostic value. Therefore, unlike the diagnostic value described above for light-emitting area 31, voltage V2 is pulled up to a high potential when light-receiving area 32 is open, and is pulled down to a low potential when light-receiving area 32 is connected. This is because it is necessary to adjust the open or short diagnostic time depending on the state of transistor TR3 of light-receiving area 32 to be diagnosed. For example, diagnosis of an open must be made when transistor TR3 is connected, i.e., when light-receiving area 32 is receiving light based on timing signal öa. On the other hand, diagnosis of a short must be made when transistor TR3 is off, i.e., when timing signal ö is low and light-receiving area 32 is in the off state and is not making measurements.

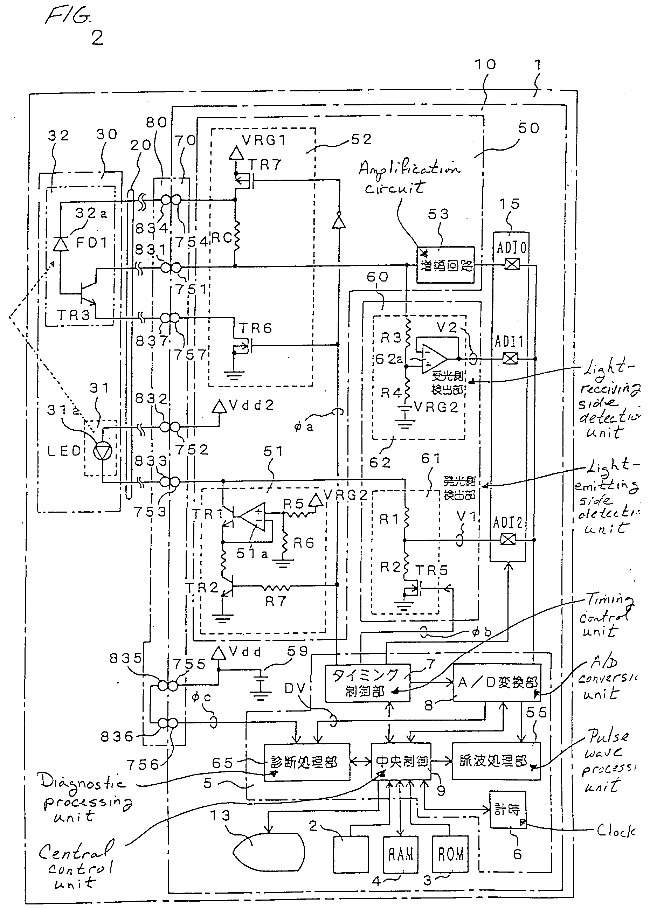

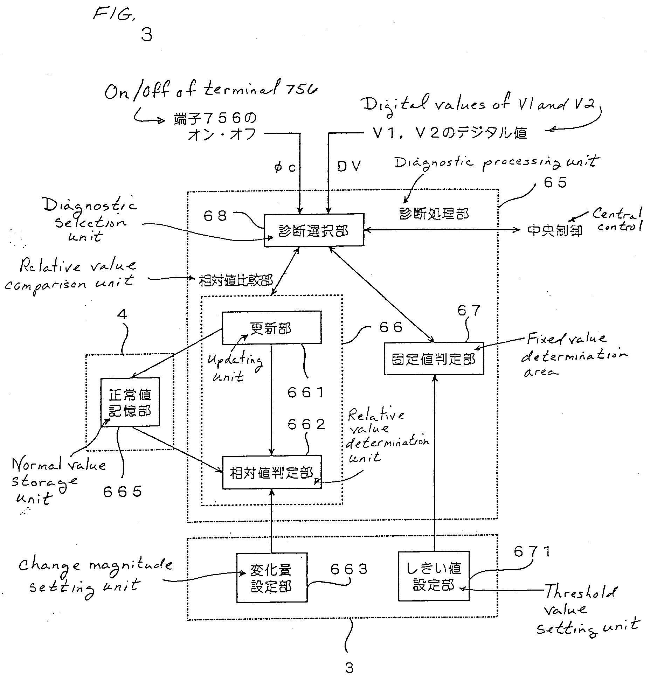

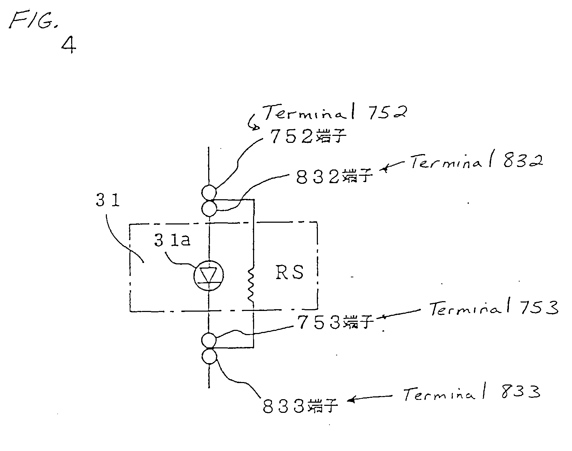

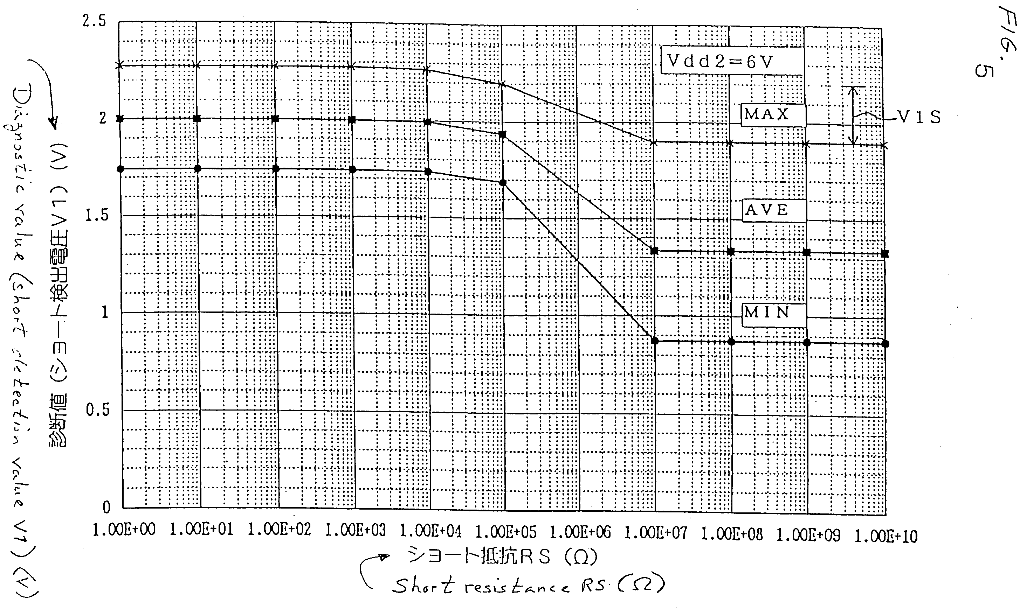

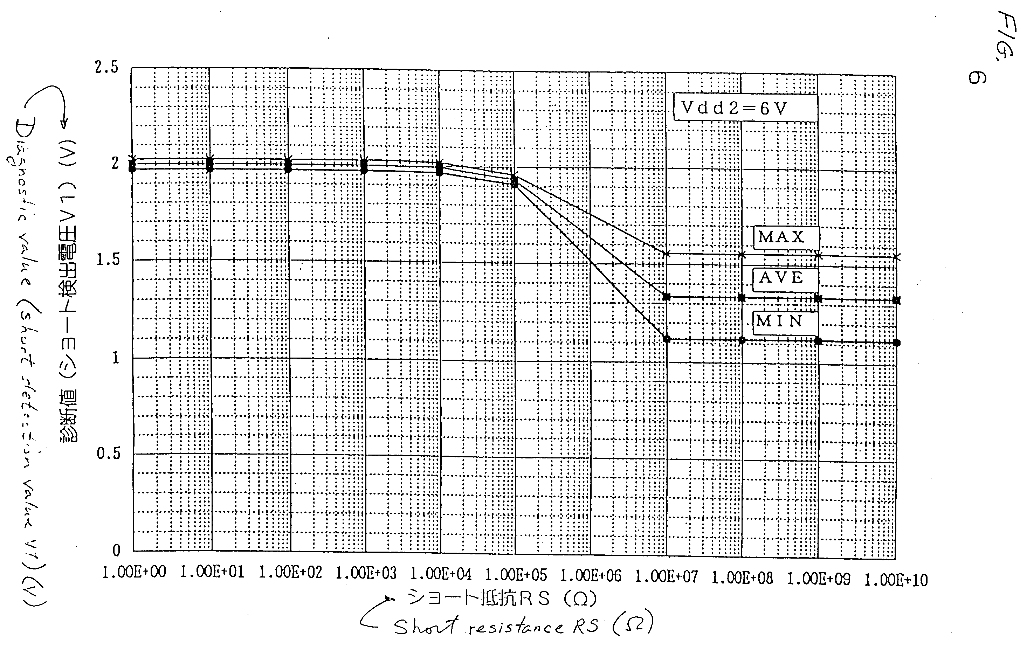

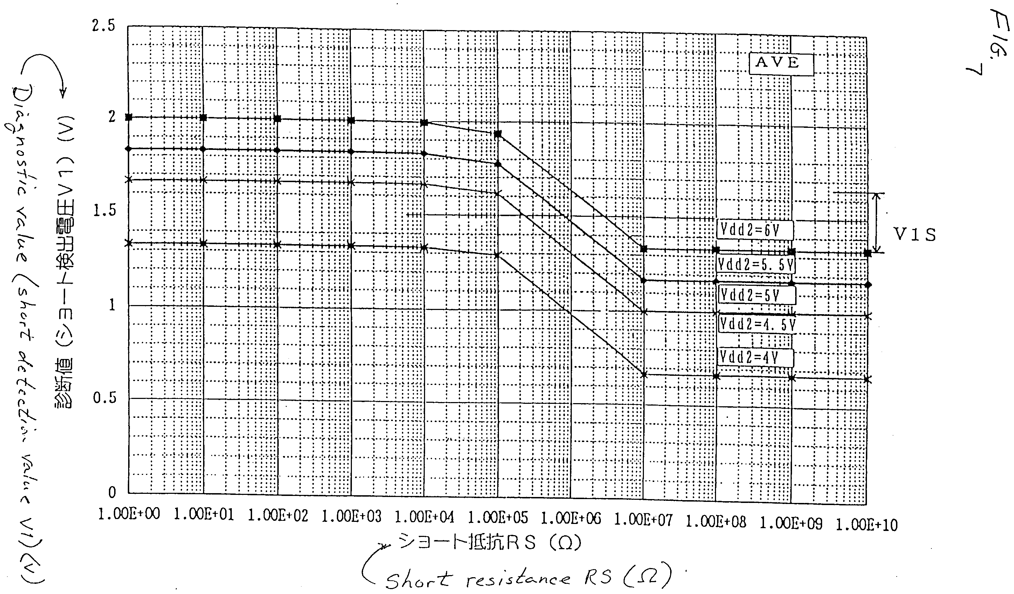

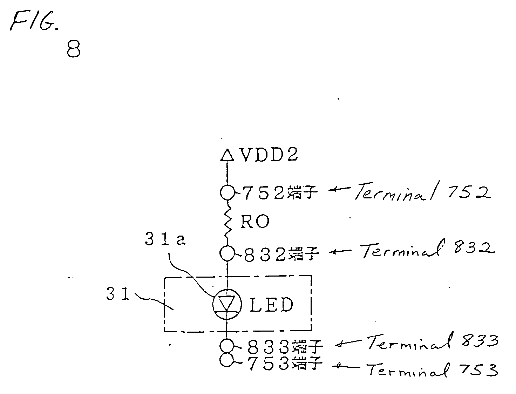

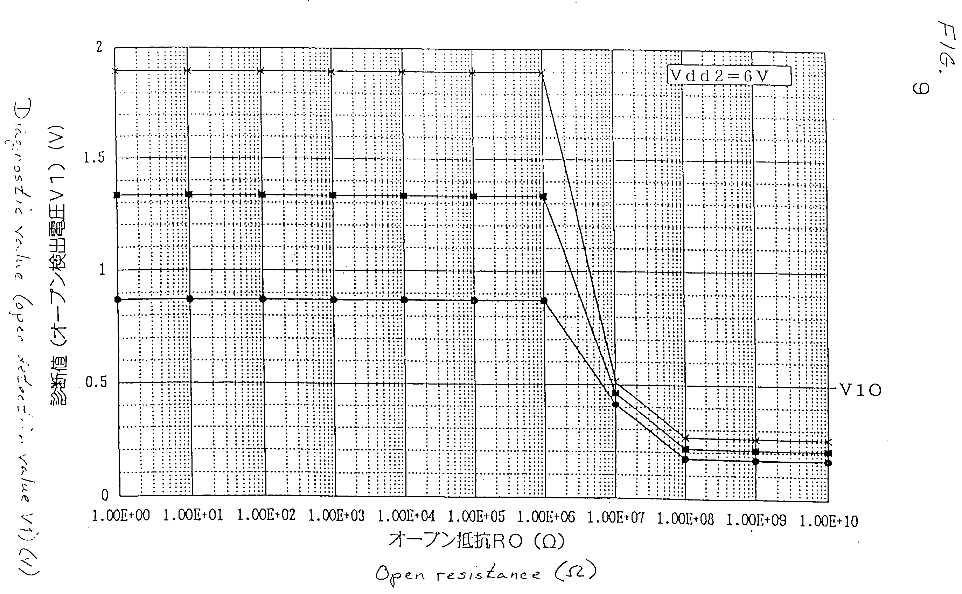

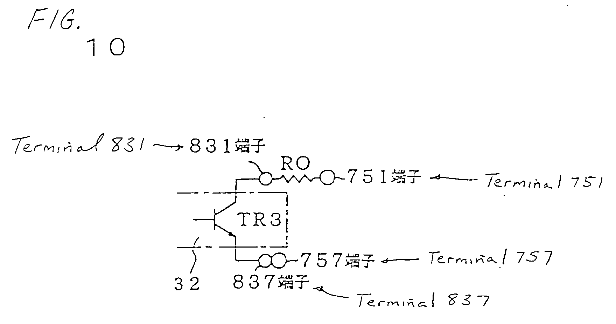

Fig. 10 shows an equivalent circuit when transistor TR3 of light-receiving area 32 is open. As shown in this figure, open resistor RO becomes connected in series with transistor TR3 when transistor TR3 of light-receiving area 32 becomes open. As before, this kind of open state may occur on the sensor unit 30 side, in cable 20, or in connector area 70 or 80.

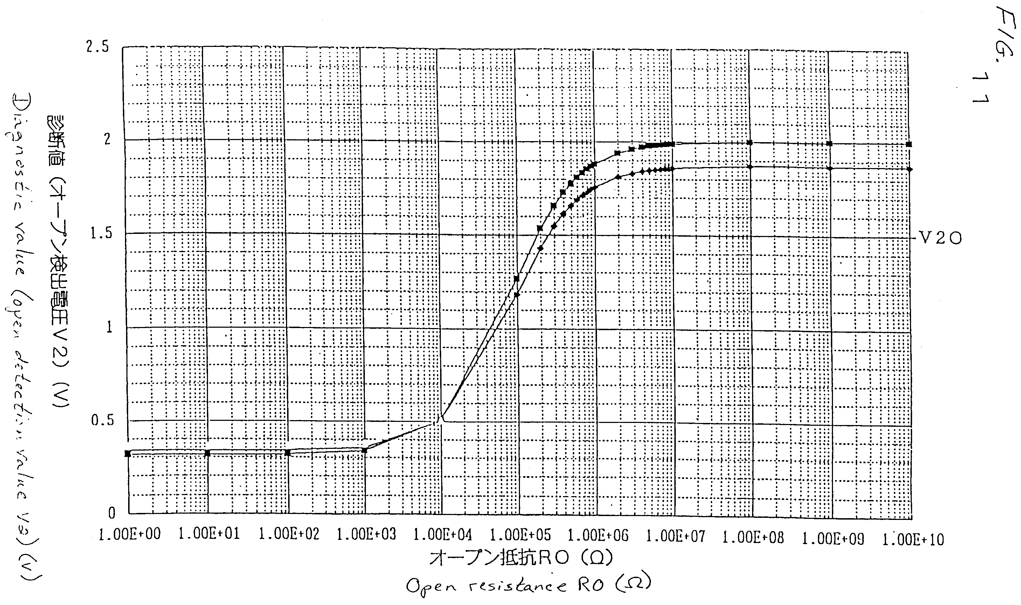

Fig. 11 shows the changes in the diagnostic value (open-detection voltage V2 in this case) obtained in light-receiving side detection circuit 62, when open resistance RO changes. As in Fig. 5, Fig. 11 shows a case in which the tolerance of the resistance values of voltage-dividing resistors R3 and R4 in light-receiving side detection circuit 62 is ±10%. As shown in Fig. 11, although open-detection voltage V2 fluctuates greatly in the region indicating an open state in which open resistance RO is large, open-detection voltage V2 fluctuates little in the region indicating a normal state in which open resistance RO is small, and is sufficiently smaller than the minimum value in the region in which open resistance RO is large. Therefore, it is possible to set judgement value V2O for determining whether or not an open state exists. For example, if the circuit state is considered to be normal when open resistance RO is 1 x 10⁴ Ù or smaller, and to be open when open resistance RO is 1 x 10⁷ Ù or greater, judgement value (threshold value) V2O of open-detection voltage V2 can be set to 1.5 V. Then, the circuit state can be determined to be normal if open-detection voltage V2 is equal to or less than judgement value of 1.5 V, and to be open if open-detection voltage V2 exceeds judgement value of 1.5 V.

### Detecting a short in the light-receiving area

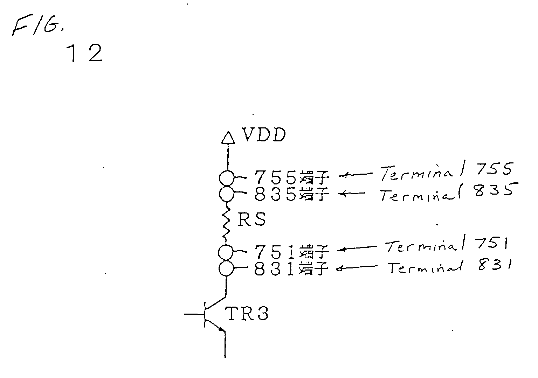

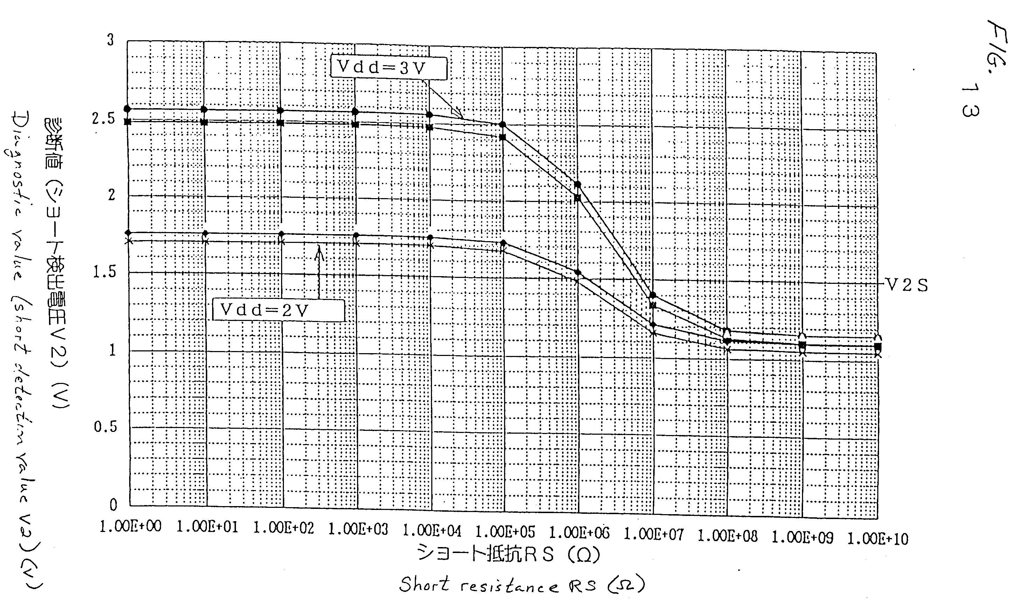

The method in which diagnostic processing area 65 of this embodiment detects a short in light-receiving area 32 is explained below. In this embodiment, as in the case of diagnosing an open, whether or not terminal 751 from which received light signals are obtained is shorted is determined, using voltage V2 acquired by the aforementioned light-receiving side detection circuit 62 and obtained from terminal 751 as the diagnostic value. For example, if a short occurs between terminal 751 and an adjacent power supply terminal 755, an equivalent circuit will result in which short resistance RS is connected between terminals 751 and 755, as shown in Fig. 12, applying power supply voltage Vdd to terminal 751 and raising the operating voltage. Fig. 13 shows the relationship between short resistance RS and short-detection voltage V2 obtained by light-receiving side detection circuit 62. Note that Fig. 13 also shows a case in which the tolerance of the resistance values of voltage-dividing resistors R3 and R4 for obtaining detection voltage V2 in light-receiving side detection circuit 62 is ±10%. For the short-detection voltage, voltage signal V2 similar to the open-detection voltage explained above is also used as the diagnostic value. The same is true for the diagnosis on the light-emitting side, and electronic instrument 1 of this embodiment uses the same signals V1 and V2 as the diagnostic values for determining short and open problems.

As shown in Fig. 13, if a case is considered in which a short in terminals 751 and 755 is to be detected, none of the circuit elements comprising this circuit configuration area have large individual differences, and furthermore, a battery voltage that is relatively more stable than the elevated voltage supplied to light-emitting area 31 is used as the power supply voltage. Consequently, although short-detection voltage V2 fluctuates in the shorted state in which short resistance RS is small, the minimum value in the shorted state is still greater than the maximum value in the region indicating a normal state in which short resistance RS is large, even when voltage Vdd fluctuates. Therefore, it is possible to set a judgement value for determining whether or not a shorted state exists. For example, if the circuit state is considered to be normal when short resistance RS is 1 x 10⁸ Ù or greater, and to be shorted when short resistance RS is 1 x 10⁵ Ù or greater[??smaller??], judgement value (threshold value) V2S of short-detection voltage (diagnostic value) V2 can be set to 1.5 V. Then, the circuit state can be determined to be normal if short-detection voltage V2 is equal to or less than judgement value of 1.5 V, and to be shorted if short-detection voltage V2 exceeds judgement value of 1.5 V.

### Problem diagnosis method

Based on the method explained above, electronic instrument 1 of this embodiment uses diagnostic processing area 65 shown in Fig. 3 to diagnose shorts and opens. That is, diagnosis of opens and shorts in light-receiving area 32 is performed using fixed value determination area 67 since a fixed judgement value can be set. Diagnosis of opens in light-emitting area 31 is also performed using fixed value determination area 67 since a fixed judgement value can be set. In contrast, diagnosis of shorts in light-emitting area 31 is performed using relative value comparison area 66 since a fixed judgement value cannot be set. In order to enable these processes, judgement value V2S for diagnosing a short in light-receiving area 32, judgement value V2O for diagnosing an open in light-receiving area 32, and judgement value V1O for diagnosing an open in light-emitting area 31 are stored in threshold value setting area 671 which stores the judgement values to be used by fixed value determination area 67. Furthermore, judgement value V1S for judging the change magnitude for indicating a short in light-emitting area 31 is stored in change magnitude setting area 663 which stores the judgement values to be used by relative value comparison area 662[??66??] for judging the change magnitude. Then, voltage signal V1 obtained by light-emitting side detection circuit 61 and voltage signal V2 obtained by light-receiving side detection circuit 62 are converted from analog to digital and are supplied as diagnostic value DV to diagnostic selection area 68, so that a diagnosis can be made. Note that signal öc which indicates whether or not connector chip 80 has been connected is also input into diagnostic selection area 68. That is, this signal is used for confirming the connection of connector chip 80, so that the connection states of light-emitting area 31 and light-receiving area 32 can be diagnosed.

### Problem diagnostic procedure

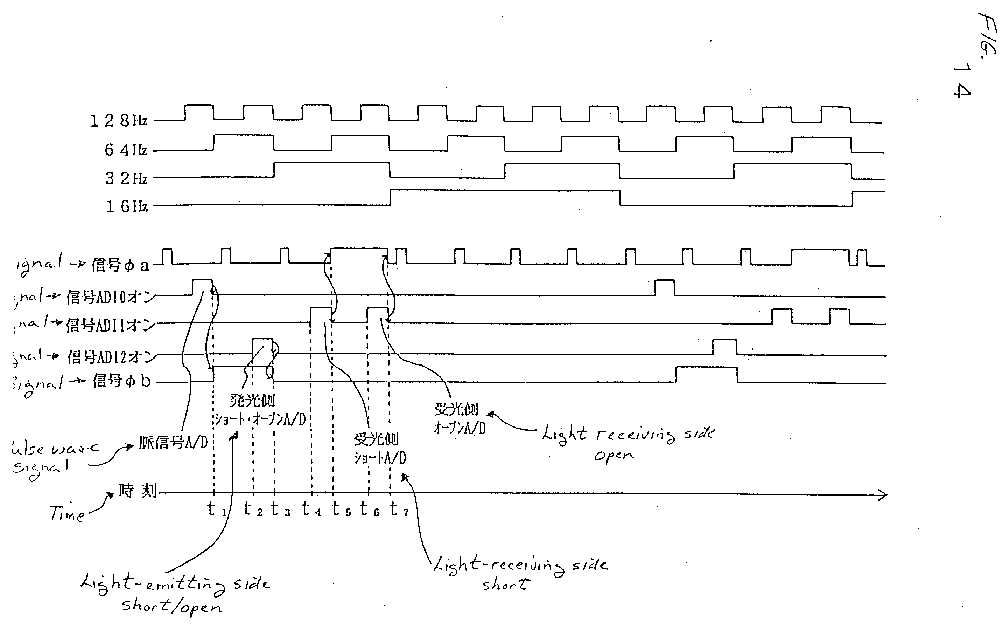

The diagnostic procedure will be explained below based on the timing diagram shown in Fig. 4 and the flow diagrams shown in Fig. 15, Fig. 16, and Fig. 17. As shown in Fig. 14, timing control area 7 of control area 5 generates a reference signal of 128 Hz, as well as reference signals of 64, 32, and 16 Hz which are obtained by dividing the first reference signal. Based on these signals, timing control area 7 outputs lighting signal öa for detecting pulse waves, lighting signal öb for diagnosing light-emitting area 31, as well as signals ADI0 ON, ADI1 ON, and ADI2 ON for selecting the signal to be supplied to A/D conversion area 8.

As explained above, signal öa is a 128-Hz signal that drives light-emitting area 31 and light-receiving area 32 for pulse wave detection. Based on this signal, light-emitting area 31 is lit and projects light onto the surface of the subject, and the reflected light is received by photodiode 32a. Then, after the received light signal is amplified by transistor TR3, the current signal is converted to a voltage signal by collector resistor RC, and this voltage signal is supplied to amplification circuit 53. Light-emitting area 31 is driven by this signal öa at its duty factor and projects light onto the surface of the subject; the received light signal is detected as a pulse wave signal at the same duty factor, and is then amplified by amplification circuit 53. This amplified signal is then sampled based on 16-Hz signal ADI0 ON and is output to A/D conversion area 52. Electronic instrument 1 of this embodiment can diagnose a connection state by utilizing the time between the processes for detecting pulse waves and calculating pulse count. Normally, the processing related to the start of this diagnosis is performed by central control area 9 which centrally controls pulse wave processing area 55 and diagnostic processing area 65, in conjunction with the processing in areas such as clock processing area 6.

As shown in Fig. 15, the processing in diagnostic processing area 65 first begins with a process for determining whether or not signal ADI0 ON has fallen in step ST1. Signal ADI0 ON falls when the sampling for converting the pulse wave signal from analog to digital has been completed. If pulse wave signal sampling is ongoing, diagnostic processing area 65 waits until signal ADI0 ON falls at time t1 and sampling is completed, and then begins a diagnostic process. In diagnostic processing area 65 of this embodiment, diagnosis is started when a diagnostic process on the light-emitting side is selected by diagnostic selection area 68.

When signal ADI0 ON falls at time t1, lighting signal öb for diagnosis is turned on in step ST2, and then signal ADI2 ON is pulled up to a high level at time t2 in step ST3, turning on multiplexer ADI2 of selection circuit 15. Based on this, voltage signal V1 of light-emitting side detection circuit 61 is obtained, converted to digital data, and is set as diagnostic value DV. Then, in step ST4, whether or not light-emitting area 31 is open is determined through fixed value diagnosis using fixed value determination area 67.

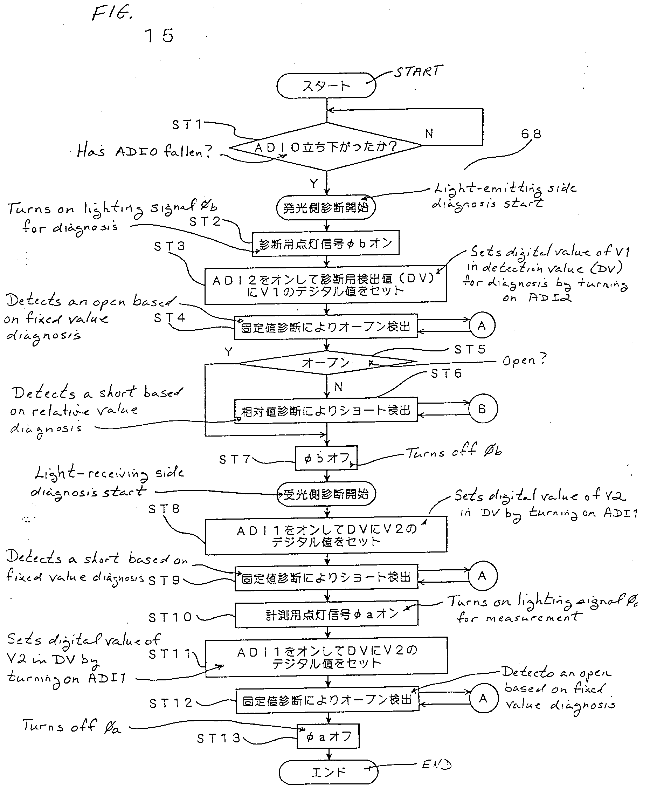

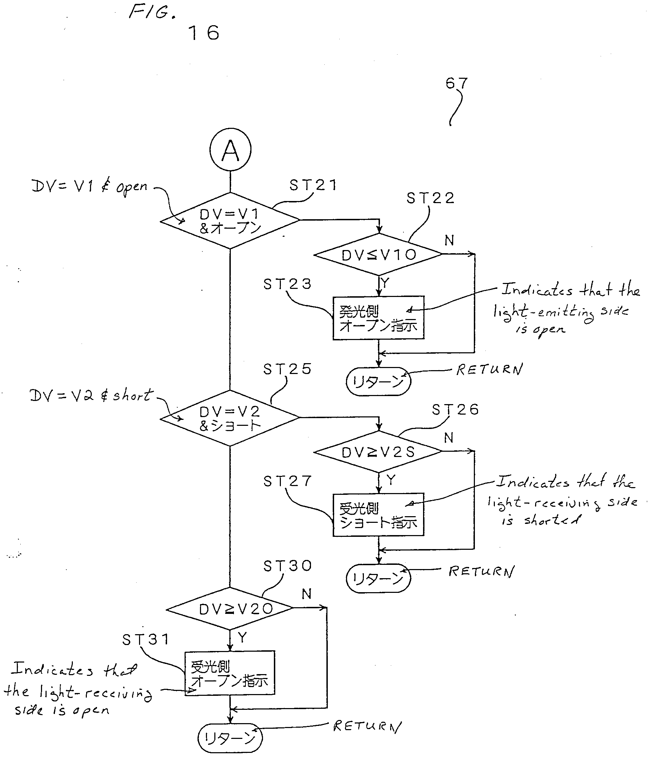

Fig. 16 shows the processing in fixed value determination area 67. First, in step ST21, it is confirmed that diagnostic value DV is voltage signal V1 for diagnosing light-emitting area 31 and it is also confirmed that diagnosis for an open is to be made. Next, in step ST22, diagnostic value DV is compared with judgement value V1O for determining whether or not light-emitting area 31 is open. This judgement value V1O is a value obtained as shown in Fig. 9, and is stored in threshold value setting area 671. If diagnostic value DV is equal to or less than judgement value V1O in step ST22, a process for displaying the fact that light-emitting area 31 is open takes place in step ST23, and the operation returns to the processing routine in diagnostic selection area 68 shown in Fig. 15. In the display process in this embodiment, a message is displayed on LCD 13 via central control area 9. Of course, it is also possible to have diagnostic processing area 65 directly control LCD 13. As explained above, in electronic instrument 1 of this embodiment, liquid crystal display device 13 also functions as a warning means for connection problems. Instead of a display, it is also possible to use other means, such as an alarm sound and a voice message, to notify the user of the diagnostic result, e.g., a short or open problem. These options can also be used in the display processes described below. On the other hand, if diagnostic value DV exceeds judgement value V1O in step ST22, the circuit is not open and no process takes place, and the operation returns to the routine in diagnostic selection area 68.

In diagnostic selection area 68, the diagnostic result of light-emitting area 31 is checked in the next step ST5. If the result is "open", it means that light-emitting area 31 has a problem. Therefore, no further diagnosis takes place, lighting signal öb is turned off, and the diagnosis of light-emitting area 31 is terminated. On the other hand, if the result is not "open" in step ST5, whether or not light-emitting area 31 has a short is determined using relative value comparison area 66 in step ST6.

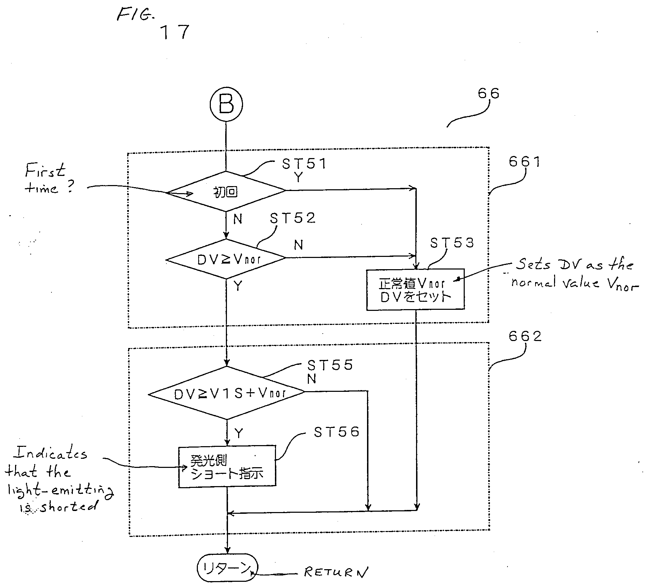

Fig. 17 shows the processing in relative value comparison area 66. In relative value comparison area 66, updating area 661 is first used to update normal value Vnor. Whether or not light-emitting area 31 is to be diagnosed for the first time is determined in step ST51. If this is the first diagnosis for light-emitting area 31, normal value Vnor has not been set. Therefore, diagnostic value DV is set in normal value Vnor in step ST53, the process is terminated, and the operation returns to the routine in diagnostic selection area 68. Whether or not the diagnosis to be made is the first one can be determined based on several timings or one of these timings. These timings can include, for example, immediately after battery replacement; immediately after connector chip 80 is installed in connector area 70, readying the instrument for pulse wave detection; and immediately after a step for starting pulse wave detection has been taken. In this embodiment, a diagnosis is considered to be the first one whenever a series of pulse count measurements are started, and thus normal value Vnor is always updated whenever a series of pulse count measurements are made.

If the diagnosis is not the first one, diagnostic value DV is compared with normal value Vnor in step ST52. If diagnostic value DV is less than normal value Vnor, there is no possibility that a short has occurred and it is presumed that a dropped power supply voltage has been reflected in diagnostic value DV. Therefore, the newly obtained diagnostic value DV is set as normal value Vnor in step ST53, the processing is terminated, and the operation returns to the routine in diagnostic selection area 68.

On the other hand, if diagnostic value DV is equal to or greater than normal value Vnor in step ST52, there is a possibility that a short has occurred. Therefore, relative value determination area 662 is used to check for a short. First, step ST55 determines whether or not diagnostic value DV is equal to or greater than the value that results when judgement value V1S is added to normal value Vnor. That is, the value that results when normal value Vnor is subtracted from diagnostic value DV, i.e., the magnitude by which diagnostic value DV has deviated from normal value Vnor, is compared with judgement value V1S. This judgement value V1S is the value obtained as the result of the evaluation explained in Fig. 5 and Fig. 7, and is stored in change magnitude setting area 663. If the value (magnitude or ratio) by which diagnostic value DV has deviated from normal value Vnor is less than judgement value V1S, no short has occurred, and thus the processing is terminated, and the operation returns to the routine in diagnostic selection area 68. On the other hand, if the value (magnitude or ratio) by which diagnostic value DV has deviated from normal value Vnor is equal to or greater than judgement value V1S, a short has occurred, and thus the fact that the light-emitting side is shorted is displayed in step ST56, and then the operation returns to the routine in diagnostic selection area 68. This completes the diagnosis of light-emitting area 31, and after lighting signal öb for diagnosis is returned to a low level at time t3 in step ST7, the diagnosis for the light-receiving side begins.

On the light-receiving side, a diagnosis for a short is performed when signal öa is off and transistor TR3 is off (open), and a diagnosis for an open is performed when signal öa is on and transistor TR3 is on (connected). Therefore, in step ST8, voltage signal V2 which becomes the diagnostic value is obtained from light-receiving side detection circuit 62 by pulling signal ADI1 ON up to a high level at time t4, and the digital value of voltage signal V2 is set as diagnostic value DV. Next, fixed value determination area 67 makes a diagnosis by comparing diagnostic value DV with judgement value V2S.

As shown in Fig. 16, in fixed value determination area 67, if it is confirmed that diagnostic value DV is equal to voltage signal V2 and that the diagnostic target is a short in step ST25, diagnostic value DV is compared with judgement value V2S stored in short threshold value setting area 671 in step ST26. A shorted state is considered to exist if diagnostic value DV is equal to or greater than judgement value V2S as shown in Fig. 13. Therefore, the fact that the light-receiving side is shorted is displayed in step ST27, and the operation returns to the routine in diagnostic selection area 68. On the other hand, if diagnostic value DV is less than judgement value V2S, the circuit is normal and the operation directly returns to the routine in diagnostic selection area 68.

When the diagnosis for a short in light-receiving area 32 is completed, signal öa for diagnosis is turned on at time t5 in step ST10 to diagnose an open in light-receiving area 32. Since turning on signal öa turns on transistor TR3, an open can be diagnosed. In step ST10, voltage signal V2 is obtained from light-receiving side detection circuit 62 by pulling signal ADI1 ON up to a high level at time t6, is digitized, and is then set as diagnostic value DV. Next, fixed value determination area 67 is used to make a diagnosis. In fixed value determination area 67 shown in Fig. 16, diagnostic value DV is compared with judgement value V2O for diagnosing an open stored in threshold value setting area 671 in step ST30. An open state is considered to exist if diagnostic value DV is equal to or greater than judgement value V2O as shown in Fig. 11. Therefore, the fact that the light-receiving side is open is displayed in step ST31, and the operation returns to the routine in diagnostic selection area 68. On the other hand, if diagnostic value DV is less than judgement value V2O, the circuit is normal and the operation directly returns to the routine in diagnostic selection area 68.

This completes the diagnosis of light-receiving area 32, and after lighting signal öa is returned to a low level at time t7 in step ST13, the diagnostic process is terminated.

In electronic instrument 1 of this embodiment, the connection state of sensor unit 30 is monitored to prevent erroneous pulse count measurement results from being output, by regularly repeating the aforementioned diagnostic processes. Furthermore, pulse count can be reliably and continuously measured, enabling the user to always obtain highly accurate measurement results. When a problem occurs, its nature and location are quickly displayed, so that the user can quickly take the necessary measures, such as resetting connector areas 70 and 80 and replacing sensor unit 30.

In particular, the diagnostic process in this embodiment described above uses a diagnostic method based on relative values. That is, a problem such as an open and short is considered to have occurred when the obtained diagnostic value has deviated by more than the specified amount from the normal value that was obtained earlier and judged to be normal. Because a problem is detected by comparing the level (intensity or value) of the diagnostic value present during a normal state with a diagnostic value that has subsequently changed, an accurate open/short detection result can be obtained even for devices in which the power supply voltage from a battery or electricity-storing device fluctuates, or for circuit elements (instruments or electrical components) such as LED and switches which have individual differences in electrical characteristics. Therefore, highly reliable measurements can be made. Furthermore, accurate diagnostic results can be obtained without requiring the user to perform any cumbersome operations such as the adjustment or resetting of the judgement value by checking the fluctuation in the power supply voltage. Moreover, because a diagnosis can be made without the effects of the electrical characteristics of the element electrically connected between terminals, etc., a highly accurate diagnosis can always be made even for a replaceable external device. Additionally, the diagnosis can be made while an external device is still connected. Moreover, because it is not necessary to provide the diagnostic device or the circuit configuration area to be diagnosed with any circuit for determining the power supply voltage or any circuit for determining the resistance value of a circuit element, a highly reliable diagnostic function having a simple configuration can be installed inexpensively. A cumbersome assembly procedure such as measuring the resistance value, etc. of each circuit element beforehand and setting an individual judgement value during the assembly of the electronic instruments, is also eliminated.

Furthermore, because the process according to the invention, which makes a diagnosis by comparing the deviation in the diagnostic value from the normal value with the judgement value, has short processing steps and can complete a diagnosis at a high speed, it can be performed utilizing the time available between measurements. Therefore, problems such as opens and shorts can be detected while performing such normal processing functions as a measurement processing function.

Moreover, in this embodiment, the diagnostic program is configured using fixed value determination which has a smaller number of processing steps and can process at high speeds, in addition to relative value determination which can cope with power supply voltage fluctuations and the individual differences in circuit elements, thus minimizing the total diagnostic time. By selecting a diagnostic method according to the circuit configuration area or the problem to be diagnosed, a fast and highly accurate diagnosis becomes possible, making it possible to provide a diagnostic processing device or diagnostic method that is ideal for portable electronic instruments that are expected to have more functions and to which more external units, etc. will be connected in the future. Especially in an instrument, such as the electronic instrument of this embodiment, that digitizes the obtained data and uses it as a measurement value or diagnostic value, diagnoses can be made without increasing the size of the processing circuit for obtaining data very much, by appropriately selecting the timings for obtaining measurement values and diagnostic values . Furthermore, a diagnosis can be easily made in parallel with other processes such as measurement processes.

Diagnostic processing area 65 equipped with such functions can of course be used for monitoring the connection states of the circuits inside the main body and the connection with display devices, etc., in addition to diagnosing the connection state with an external unit such as a sensor unit as in this embodiment. Furthermore, although the diagnostic processing area in this embodiment uses a relative value comparison area for diagnosing a short in the light-emitting area, the diagnostic method according to the invention can of course be applied to diagnosing an open in the light-emitting area and an open/short in other circuit configuration areas. Moreover, although an example in which a voltage signal is set as the diagnostic value is explained in the aforementioned embodiment, a current value can of course be used as the diagnostic value. That is, a signal that is convenient for diagnosing a circuit configuration area or for obtaining a diagnostic value can be used.

Furthermore, the diagnostic method according to the invention is not limited in its application to wristwatch-type electronic instrument 1, and can of course be provided as a software program for diagnosing a processing device in which an external sensor, etc. is connected to a personal computer, etc. to obtain and analyze measurement values such as pulse wave data. The software that uses the diagnostic method according to the invention can accurately diagnose the connection states of battery-operated external sensor units and notebook computers as well, and can monitor connection states without being affected by individual characteristics of external sensors even when a large number of external sensors are connected. Such a software program can be provided as a program stored in a magnetic recording medium such as a floppy disk and hard disk, or in a medium such as a CD and ROM that can be read by a computer, microprocessor, etc.

Naturally, the diagnostic device and the diagnostic method according to the invention are not limited in their applicability to devices or methods for diagnosing the connection states of external units that measure pulse waves, etc., and can be used in a wide range of fields such as communication and POS.

Note that the numerical values, such as voltages and judgement values, referenced above during explanations are merely examples, and the invention is of course not limited to these numerical values.

### Overall configuration of the portable electronic instrument

The configuration of the aforementioned portable electronic instrument equipped with the measurement function according to the invention will be explained in more details below.

Returning to Fig. 1, wrist-mountable electronic instrument 1 of this embodiment is equipped with a pulse wave measurement function, and is detachably mounted on the user's wrist using belt-shaped wristband 12 which is made of natural leather, synthetic leather, synthetic fabric sheet, natural fabric sheet, etc. and which is wound around the wrist from the 12 o'clock direction of device main body 10 and folded back from the 6 o'clock direction. Sensor unit 30 for pulse wave measurement, which is connected to the main body via cable 20, is designed to be able to be mounted on the base of the index finger (subject's body) using sensor-fastening strap 40.

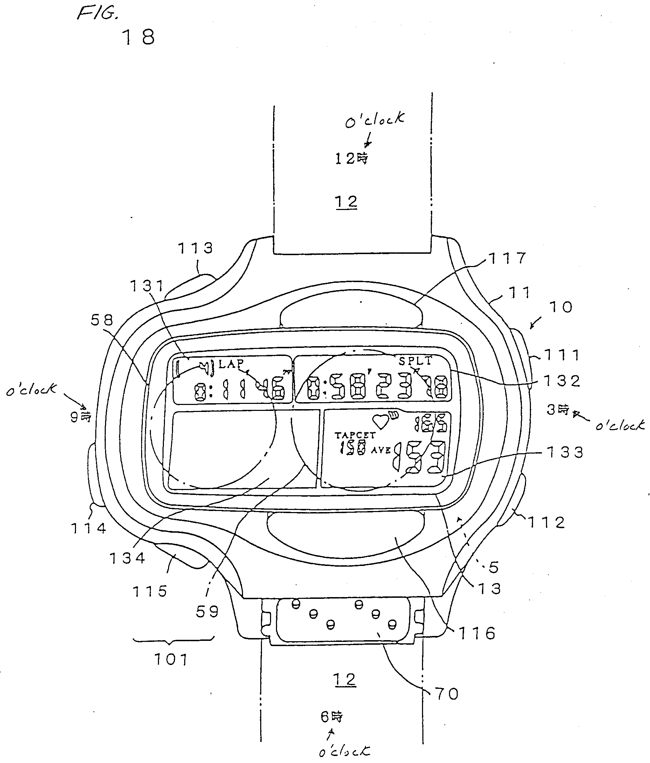

Fig. 18 shows the main body of the wrist-mountable pulse wave measurement instrument of this embodiment, with the wristband, cable, etc. removed. Device main body 10 is provided with plastic watch case 11 (body case), and the top side of this watch case 11 is provided with liquid crystal display device 13 (display area) for digitally displaying pulse wave information such as pulse count, and the problem detected by the diagnostic function, in addition to the current time and date. Liquid crystal display device 13 is provided with first through third segment display areas 131 through 133, and dot display area 134. Furthermore, control area 5, which applies signal processing to the detection result in order to display pulse count change, etc., based on the detection result (pulse wave signal) from sensor unit 30, is provided inside watch case 11. Control area 5 is also provided with a timing circuit and thus can display information such as normal time, lap time, and split time on liquid crystal display device 13.

Button switches 111 through 115, which are used for operations such as time adjustment and display mode switching, are provided on the perimeter of watch case 11. Additionally, button switches 116 and 117 are provided on the surface of watch case 11. Furthermore, button-shaped battery 59, which acts as the power supply for wrist-mountable electronic instrument 1, is housed inside watch case 11, as explained above.

In wrist-mountable electronic instrument 1 of this embodiment, the size of device main body 10 must be increased as more functions are added. However, it is difficult to extend device main body 10 in the 6 or 12 o'clock directions of the watch because it must be worn around a wrist. Therefore, device main body 10 uses watch case 11 which is longer in the 3 and 9 o'clock directions than in the 6 and 12 o'clock directions. To watch case 11 having such a shape, wristband 12 is connected eccentrically toward the 3 o'clock side and away from the central position between the 3 o'clock and 9 o'clock positions. Therefore, device main body 10 has large extended area 101 in the 9 o'clock direction of the wristwatch, viewed from wristband 12. However, no such extended area is provided in the 3 o'clock direction. Consequently, this structure, despite the use of laterally long watch case 11, offers excellent wearability, allowing free wrist movements, for example. Furthermore, because no large extended area is present in the 3 o'clock direction, the possibility of the back of the hand striking watch case 11 during a fall is eliminated. Moreover, because large extended area 101 positioned in the 9 o'clock direction is supported while tightly contacting the arm surface on the elbow side, wrist-mountable pulse wave measurement instrument 1 is stable. Consequently, it is not necessary to use unnecessarily wide wristband 12 despite the use of laterally long watch case 11.

Because flat battery 59 for the power supply and flat piezoelectric element 58 for the buzzer are positioned side by side in the planar direction (in the 3 o'clock and 9 o'clock directions in the wristwatch), device main body 10 can remain thin, and the battery cover provided on the back side allows the user to easily replace battery 59. Battery 59 is positioned eccentrically in the 3 o'clock direction while piezoelectric element 58 is eccentrically positioned in the 9 o'clock direction. Note that because battery 59 is heavier than piezoelectric element 58 , the center of gravity of device main body 10 in the 3 o'clock to 9 o'clock direction is shifted toward the 3 o'clock direction. Since wristband 12 is connected to the side to which the center of gravity has shifted, device main body 10 can be securely attached to the wrist.

### Sensor unit configuration

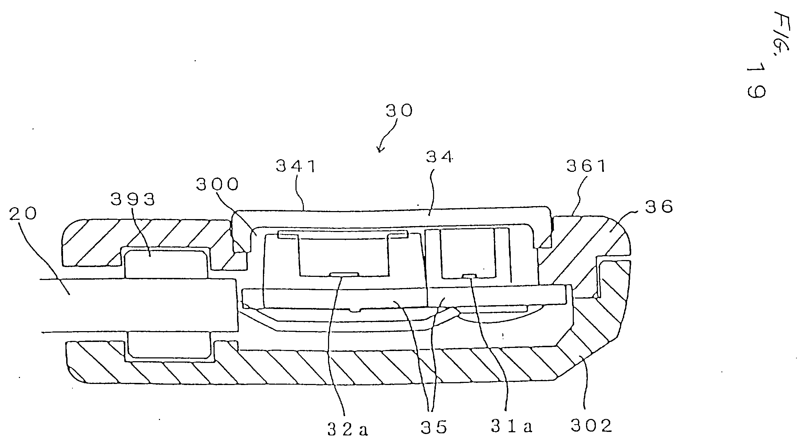

Fig. 19 is a cross-section showing the structure of the sensor unit. In sensor unit 30 of this embodiment, component housing space 300 is formed by placing back lid 302 on the bottom side of sensor frame 36 which constitutes a casing body. A light transmission window is formed using glass plate 34 (filter) on the upper area of sensor frame 36, and circuit board 35 is fastened inside sensor frame 36, facing said glass plate 304[??34??]. Electronic components such as LED 31a, photodiode 32a, and transistors (not shown in the figure) are mounted on circuit board 35. The light-emitting surface and light-receiving surface of LED 31a and photodiode 32a, respectively, are positioned while being oriented toward said glass plate 34. Note that one end of cable 20 is fastened by bushing 393, and the various wires are soldered to the patterns on circuit board 35.

In this embodiment, an InGaN (indium-gallium-nitrogen) blue LED is used as LED 31, and its emission spectrum possesses a peak at 450 nm and its emission wavelength ranges from 350 to 600 nm. To match with LED 31 possessing such characteristics, a GaAsP (gallium-arsenic-phosphorus) photodiode is used as photodiode 32a, and the light-receiving wavelength of the element itself ranges from 300 to 600 nm, with some sensitive areas also at or below 300 nm.

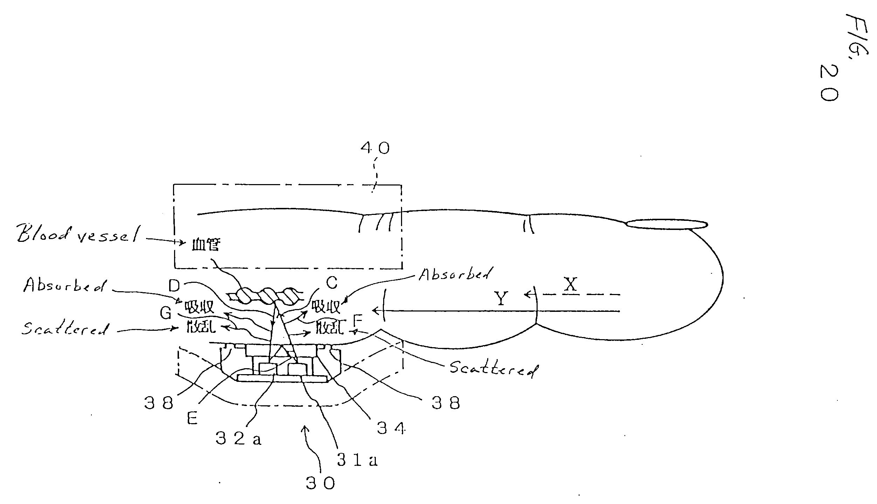

As shown in Fig. 20, when sensor unit 30 is attached to the base of a finger by sensor-fastening strap 40, the light-emitting surface and light-receiving surface of LED 31a and photodiode 32a, respectively, are oriented toward the finger surface. During this procedure, body-grounding terminal 38 also contacts the finger surface. From this state, when LED 31a projects light toward the finger, photodiode 32a receives the light reflected from the subject (blood vessel). Then, when the received light result (pulse wave signal) is input into device main body 10 via cable 20, device main body 10 determines pulse count from the pulse wave signal.

### Configuration of the pulse wave data processing area

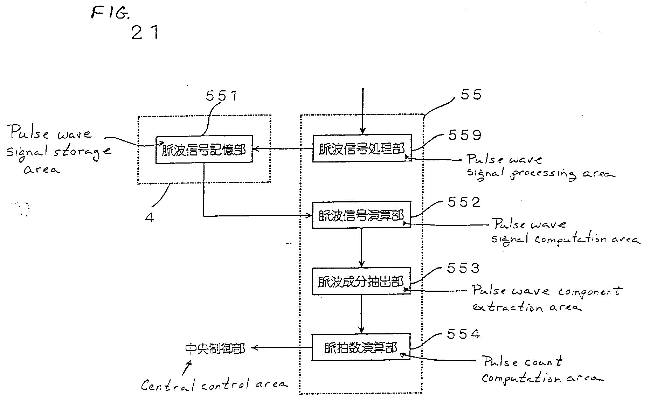

Fig. 21 is a block diagram schematically showing the functions of pulse wave processing area 55 provided in control area 5 of main body 10. Digitized data is temporarily stored in pulse wave signal storage area 551 of RAM4 via pulse wave signal processing area 559. This data is supplied to pulse wave signal computation area 552, and frequency analysis (fast Fourier transformation) is performed. From the result of this analysis, pulse wave component extraction area 553 identifies and extracts pulse wave components, pulse count computation area 554 computes pulse count from the frequency component of the input pulse wave, and the result is displayed on liquid crystal display device 13 via central control area 9.

### Configuration of the connector area

Cable 20 and sensor unit 30 are designed to be installed/removed on the top surface of the edge area located in the 6 o'clock direction of device main body 10 so that wrist-mountable portable electronic instrument 1 of this embodiment can be treated like an ordinary wristwatch during ordinary usage. That is, connector area 70 is provided in the 6 o'clock direction of the edge area of device main body 10, so that connector piece 80 (connector component) provided on the end of cable 20 can be installed. Therefore, when sensor unit 30 and cable 20 are removed from device main body 10, the instrument can be used as an ordinary wristwatch, which is convenient. Moreover, because connector area 70 is located in the 6 o'clock direction, connector area 70 is located toward the user when device main body 10 is mounted on the wrist, which makes operations simple. Furthermore, since connector area 70 does not extend from device main body 10 in the 3 o'clock direction, the user can freely move the wrist during running and the back of the hand will not strike connector area 70 even if the user falls during running.

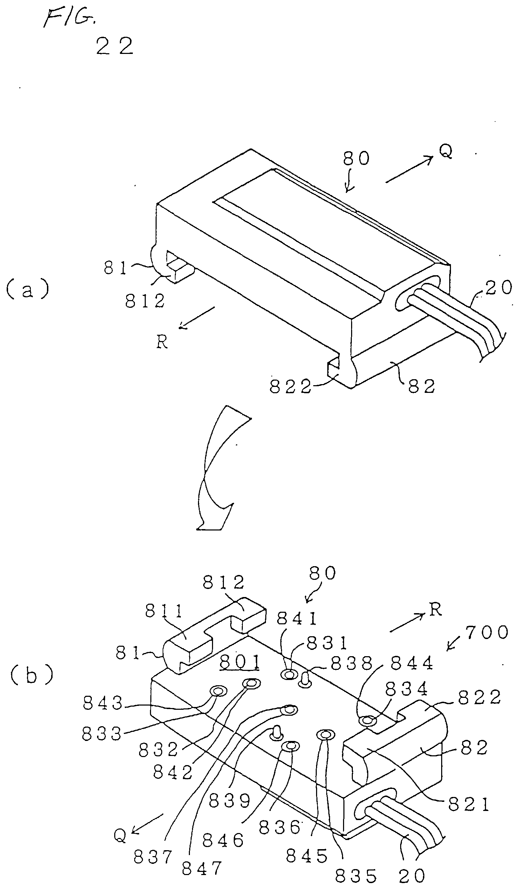

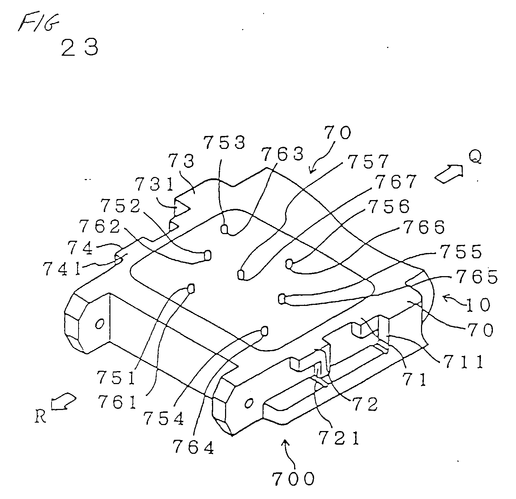

The structures of such connector area 70 and connector piece 80 will be explained using the connector piece (shown in Fig. 22) provided on the end of the cable and the connector area (shown in Fig. 23) in which the connector piece is to be installed. Fig. 22 (a) shows connector piece 80 viewed from the top surface (upper surface), and Fig. 22 (b) shows connector piece 80 viewed from the bottom surface (lower surface), i.e., from the side to be connected. A pair of protruding areas 81 and 82, which protrude downward on both sides of connector piece 80, are formed on bottom surface area 801 of connector piece 80. Four engagement pieces 811, 812, 821, and 822 protrude inward from the bottom edges of these protruding areas 81 and 82. Seven terminals 831, 832, 833, 834, 835, 836, and 837 are formed on bottom surface area 801 of connector piece 80, and ring-shaped ridges 841, 842, 843, 844, 845, 846, and 847 are formed around these terminals. To install connector piece 80 in connector area 70, connector piece 80 is first placed over connector area 70, and then connector piece 80 is slid in the direction of arrow Q. Of the terminals 831 through 836, terminals 831, 832, and 833 and terminals 834, 835, and 836 are formed in two lines along the sliding direction (direction of arrow Q). In both of these lines, terminals 831 through 836 are positioned so that they are obliquely offset in the direction perpendicular to the sliding direction (direction of arrow Q) of connector piece 80.

Furthermore, two activation pins 838 and 839 for opening/closing the gap between LED 31 and photodiode 32 are provided on the bottom surface of connector piece 80, in order to prevent the effect of static electricity when cable 20 is installed in device main body 10. The tips of these activation pins 838 and 839 are protruding from bottom surface area 801 of connector piece 80 when connector piece 80 is removed from connector area 70, and move in the retracting direction when connector piece 80 is installed in connector area 70.

As the magnified view of connector area 70 of main body 10 shown in Fig. 23 indicates, engagement areas 71, 72, 73, and 74 which protrude outward are formed on connector area 70. Therefore, after connector piece 80 is placed over connector area 70 such that protruding areas 81 and 82 of connector piece 80 are positioned outside engagement areas 71, 72, 73, and 74 of connector area 70 and at the same time engagement pieces 811 and 821 are positioned between engagement areas 71 and 72 and between engagement areas 73 and 74, respectively; connector piece 80 is pressed toward connector area 70 (this is the first operation for installing connector piece 80 in connector area 70) so that engagement pieces 811 and 821 pass through the spaces between engagement areas 71 and 72 and between engagement areas 73 and 74, respectively. Then, afterwards, when connector piece 80 is slid in the direction of arrow Q (connector piece 80 installation direction, or from the 6 o'clock direction to the 12 o'clock direction in device main body 10) (this is the second operation for installing connector piece 80 in connector area 70), engagement pieces 811 and 821 slide under engagement areas 71 and 73, respectively. Also, engagement pieces 812 and 822 slide under engagement areas 72 and 74, respectively. As a result, engagement areas 71, 72, 73, and 74 are held between engagement pieces 811, 821, 812, and 822, respectively, and bottom surface area 801 of connector piece 80, and thus connector piece 80 is simply and securely installed in connector area 70.

Seven terminals 751 through 756[??757??] are provided on the top side of connector area 70. Of these terminals 751 through 756, terminals 751, 752, and 753 and terminals 754, 755, and 756 are formed in two lines along the sliding direction (direction of arrow Q) of connector piece 80, in the same way as terminals 831 through 836. In both of these lines, terminals 751 through 756 are positioned so that they are obliquely offset in the direction perpendicular to the sliding direction (direction of arrow Q) of connector piece 80, in the same way as terminals 831 through 836. Therefore, when connector piece 80 is installed in connector area 70, terminals 831 through 837 and terminals 751 through 757, respectively, become electrically connected, so that the measurement result from sensor unit 30 can be input into device main body 10 via cable 20.

As explained above, terminals 751 through 756 and terminals 831 through 836 are formed in two lines along the sliding direction of connector piece 80, and the positions between the individual terminals and individual electrodes are obliquely offset in the direction perpendicular to this sliding direction. Therefore, even when connector piece 80 is slid onto connector area 70, the non-corresponding terminals of terminals 751 through 756 and terminals 831 through 836 will not contact each other. Moreover, even when a small area is used for forming connector area 70, terminals can be positioned in separate locations, and thus terminals are less likely to be shorted even when water enters between connector piece 80 and connector area 70.

### Operation for using the wrist-mountable electronic instrument for pulse count measurement

The operation for using the wrist-mountable electronic instrument 1 thus configured for pulse count measurement will be briefly explained with reference to Fig. 1. First, in Fig. 1, for using wrist-mountable electronic instrument 1 as an ordinary wristwatch, device main body 10 is mounted on the wrist using wristband 12, with cable 20 and sensor unit 30 removed from connector area 70 of device main body 10. When doing so, a connector cover can be placed on connector area 70 in order to improve the appearance and to protect connector area 70.

Next, for using wrist-mountable electronic instrument 1 to measure pulse count during running, cable 20 is connected to device main body 10 by installing connector piece 80 in connector area 70, and the device main body 10 is mounted on the wrist using wristband 12. Sensor unit 30 is then adhered closely to a finger using sensor-fastening strap 40, and then the user begins running.

From this state, as shown in Fig. 20, when LED 31a projects light toward the finger, the light reaches blood vessels, and part of this light is absorbed by the hemoglobin in the blood and part of it is reflected. Photodiode 32a receives the light reflected from the finger (blood vessel), and the change in the amount of received light corresponds to the change in blood volume caused by pulse waves in the blood. That is, because the reflected light becomes weak when the blood volume is high and becomes strong when the blood volume is low, data such as pulse count can be measured by monitoring the intensity of the reflected light using photodiode 32a. In order to perform such detection, pulse wave processing area 55 shown in Fig. 21 converts the signal that is input from photodiode 32a (sensor unit 30) to a digital signal, and performs frequency analysis, etc. on this digital signal to calculate pulse count. The pulse count determined from the calculation is then displayed on liquid crystal display device 13. That is, wrist-mountable electronic instrument 1 functions as a pulse counter.

Note that, in Fig. 20, the light projected from LED 31a for pulse wave measurement reaches the blood vessel through the finger as indicated by arrow C, and the reflected light from the hemoglobin in the blood reaches photodiode 32a for pulse wave measurement as indicated by arrow D. The amount of light received through this route is the biological reflection amount. Part of the light projected from LED 31a for pulse wave measurement is reflected by the finger surface and also reaches photodiode 32a for pulse wave measurement as indicated by arrow E. The amount of light received through this route is the skin reflection amount. Moreover, part of the light projected from LED 31a for pulse wave measurement and part of the light reflected from the blood vessel are absorbed or scattered within the finger, and thus do not reach photodiode 32a for pulse wave measurement. Here, LED 31a for pulse wave measurement having an emission wavelength range of between 350 and 600 nm and photodiode 32a for pulse wave measurement having a light-receiving wavelength range of between 300 and 600 nm are used for sensor unit 30, and biological information is displayed based the detection result in the overlapping wavelength region, i.e., from approximately 300 nm to approximately 600 nm. Because lights with wavelengths of 700 nm or shorter contained in the ambient light do not easily penetrate the finger, the ambient light reaching the area of the finger not covered by the sensor fastening strap 40 will not use the finger as a light guide to reach phototransistor 32a (light-receiving area) for pulse wave measurement, as indicated by dotted line X in Fig. 20, and therefore only the lights in the wavelengths that do not affect the detection come through using the finger as a light guide. Furthermore, because lights with wavelengths of 300 nm or shorter are mostly absorbed by the skin surface, the effective light-receiving wavelength range will be between 300 and 700 nm even if a range of 700 nm or less is set. Therefore, by covering only the minimally necessary area of a finger, without the need to cover a large area, the effect of the ambient light can be suppressed, and moreover small sensor unit 30 such as that used in this embodiment allows the user to clench the fist while wearing the instrument and thus does not interfere with running. Furthermore, installing sensor unit 30 at the base of the finger allows cable 20 to be short, and thus cable 20 does not interfere with running. Furthermore, because the blood flow at the base of the finger does not substantially fall even when the weather is cold, as evidenced by the fact that the temperature at the base of the finger falls relatively little, pulse count, etc. can be accurately measured even during running outside on a cold day. Therefore, wrist-mountable pulse wave measurement device 1 of this embodiment is ideal for measuring pulse count, etc. during jogging or running.

In contrast, if an LED possessing an emission peak at around 880 nm and a silicon-based photodiode for pulse wave measurement are used, its light-receiving wavelength range will be between 350 and 1,200 nm. Since a conventional optical system (detection system) detects pulse waves based on the detection result of a light with 1 ìm wavelength which is contained in the ambient light and which can use the finger as a light guide to easily reach the light-receiving area for pulse wave measurement as indicated by arrow Y in Fig. 20, the fluctuation in the ambient light condition tends to cause faulty detection results.

Furthermore, because pulse wave information is obtained using lights in the wavelength range between approximately 300 and approximately 700 nm, the S/N ratio of the pulse wave signal based on blood volume change is high. That is, in the relationship between light wavelengths and various types of hemoglobin light absorption characteristics, the absorption coefficient of hemoglobin in the blood for lights with wavelengths of between 300 and 700 nm is several times to approximately one hundred or more times larger than the absorption coefficient for a light with wavelength of 800 nm.

Note that, from the viewpoint of obtaining pulse wave information without being affected by the ambient light, it is also possible to use a GaP-based LED for pulse wave measurement having the primary emission wavelength range of between 540 and 570 nm and a GaP-based photodiode for pulse wave measurement having a sensitive region from 200 to approximately 700 nm.

As explained above, wrist-mountable electronic instrument 1 in this embodiment is designed to display pulse count at high accuracy by detecting pulse waves using sensor unit 30 installed in device main body 10. Moreover, because sensor unit 30 is configured to be able to be installed and removed using a connector, electronic instrument 1 in this embodiment can be used as an ordinary watch as well as a pulse counter when it is mounted on the wrist during an activity such as marathon. Note that because the electronic instrument is portable, the area occupied by the connector is small, making it difficult to allocate sufficient area for connection. Since the connector area and the cable tend to be subjected to relatively rough use in this kind of configuration, pulse count is measured while using the diagnostic method according to the invention described above to check the connection state frequently, so that highly reliable data can be displayed.

Additionally, the diagnostic device and the diagnostic method according to the invention are designed to be able to perform relative value determination in which a diagnostic value for detecting a problem is first stored as a normal value if that diagnostic value is determined to be normal, and then diagnosis is made by comparing the change in a subsequent diagnostic value with a preset judgement value that indicates the fluctuation limit. Because the diagnostic device and the diagnostic method according to the invention can detect problems such as opens and shorts through relative comparison against a normal diagnostic value, they can accurately diagnose problems such as opens and shorts even when the power supply voltage fluctuates or individual differences exist among circuit elements of instruments.

Moreover, the diagnostic results obtained using the diagnostic method and the diagnostic device according to the invention are not affected by the electrical characteristics of the elements electrically connected between terminals, etc. Therefore, the invention is ideal for use in methods or devices that diagnose the connection state of a replaceable external device, such as a sensor device, that is connected via the connector area of the device main body, and problem diagnosis can be made while the sensor device, etc. is installed and while the external device, such as a sensor device, etc., is running.

Furthermore, the diagnostic device and the diagnostic method according to the invention are designed to provide highly accurate diagnoses through digital processing by comparing the change in the diagnostic value from the normal value with the specified judgement value. Therefore, the invention is ideal for diagnosing compact electronic instruments in which digital conversion is in progress for processes such as pulse wave measurement, making it possible to output highly accurate measurement values at all times by performing diagnostic processes in parallel with the functions of the instruments. Therefore, the diagnostic device and the diagnostic method according to the invention are ideal for use in compact and multi-function portable electronic instruments in which digital conversion of processes is in progress, and can be applied to various kinds of processes in the future.

### Industrial Application Potential

The invention relates to a diagnostic device and a diagnostic method that can detect problems such as opens and shorts by diagnosing the connection states of connector areas and wiring areas of circuit configuration areas equipped with circuit elements such as an LED, and the invention can accurately detect problems even when the power supply voltage fluctuates or large individual differences exist among circuit elements.

## Claims

1. A connection state diagnostic device that can diagnose open or short problems in a circuit configuration area by obtaining a diagnostic value based on the operating voltage or operating current in said circuit configuration area,
having an updating means that stores said diagnostic value as a normal value if said diagnostic value is judged to be normal,
and a relative value determination means that diagnoses said problems by comparing the change in said diagnostic value relative to said normal value with a judgement value.

2. A connection state diagnostic device according to Claim 1 wherein, at least during the diagnosis, said circuit configuration area is driven by the power supplied from an electricity-storing device.

3. A connection state diagnostic device according to Claim 1 wherein said circuit configuration area is provided with circuit elements having large individual differences.

4. A connection state diagnostic device according to Claim 1 further having a fixed value determination means that diagnoses said problems by directly comparing said diagnostic value with the judgement value,
and a selection means that selects either said relative value determination means or said fixed value determination means based on the type of said circuit configuration area or said problem.

5. A portable electronic instrument having a main body provided with a measurement function, a sensor area that is connected to said main body via a removable connector and that can detect signals from a measurement target, and a diagnostic area that can diagnose open or short problems in said circuit configuration area by obtaining a diagnostic value based on the operating voltage or operating current in the circuit configuration area of said sensor area,
with an updating means that stores said diagnostic value as a normal value if said diagnostic area judges said diagnostic value to be normal, and
with a relative value determination means that diagnoses said problems by comparing the change in said diagnostic value relative to said normal value with a judgement value.

6. A portable electronic instrument according to Claim 5, having a measurement area that uses said sensor area to intermittently make measurements and a control area that operates said diagnostic area between the measurements being made by said measurement area.

7. A connection state diagnostic method that can diagnose open or short problems in a circuit configuration area by obtaining a diagnostic value based on the operating voltage or operating current in said circuit configuration area,
having an updating process in which said diagnostic value is stored as a normal value if said diagnostic value is judged to be normal,
and a relative value determination process in which said problems are diagnosed by comparing the change in said diagnostic value relative to said normal value with a judgement value.

8. A connection state diagnostic method according to Claim 7 wherein, at least during the diagnosis, said circuit configuration area is driven by the power supplied from an electricity-storing device.

9. A connection state diagnostic method according to Claim 7 wherein said circuit configuration area is provided with circuit elements having large individual differences.

10. A connection state diagnostic method according to Claim 7 further having a fixed value determination process in which said problems are diagnosed by directly comparing said diagnostic value with a judgement value,
and a selection process in which either said relative value determination process or said fixed value determination process is selected based on the type of said circuit configuration area or said problem before either said relative value determination process or said fixed value determination process takes place.
